# EUROPEAN PATENT APPLICATION

(11) **EP 4 518 343 A1**
(43) Date of publication of application: **05.03.2025**
(21) Application number: 24194395.0
(22) Date of filing: 13.08.2024
(51) Int. Cl.: H04N 25/709, H01L 27/146, H04N 25/773

(54) **PHOTOELECTRIC CONVERSION APPARATUS, PHOTOELECTRIC CONVERSION SYSTEM, AND MOVABLE BODY BACKGROUND**

(30) Priority: 28.08.2023 JP 2023138474; 17.06.2024 JP 2024097731
(71) Applicant: CANON KABUSHIKI KAISHA, Tokyo 146-8501 (JP)
(72) Inventor: SASAGO, Tomoya, Tokyo, 146-8501 (JP); MATSUNO, Yasushi, Tokyo, 146-8501 (JP); MORIMOTO, Kazuhiro, Tokyo, 146-8501 (JP); ENDO, Wataru, Tokyo, 146-8501 (JP); MAEHASHI, Yu, Tokyo, 146-8501 (JP)
(74) Representative: Canon Europe Limited

(57) **Abstract**

A photoelectric conversion apparatus (100, Figure 1) includes an avalanche photodiode 210 having a first terminal and a second terminal, a first power source (601) connected to the first terminal, a second power source (602) connected to the second terminal, a charge unit (202) configured to control a voltage of the first terminal, a voltage control unit (604) connected to the first terminal and configured to control a voltage of the first terminal in accordance with a voltage of the first terminal, and a third power source (603) connected with the voltage control unit.

## Description

### BACKGROUND

### Field

The present disclosure relates to a photoelectric conversion apparatus, a photoelectric conversion system including the photoelectric conversion apparatus, and a movable body including the photoelectric conversion apparatus.

### Description of the Related Art

Photoelectric conversion apparatuses in which pixels including a plurality of avalanche photodiodes (hereinafter, APDs) are disposed is known. Avalanche multiplication caused by photocharges generated by photon incidence on the APD is utilized to execute single photon level photodetection in each pixel.

Japanese Patent Application Laid-Open Publication No. 2020-123847 discusses a photodetection apparatus that has a charge unit between a cathode of an APD and a supply line of a source voltage to switch state between a charge state and a standby state which is to wait for photon incidence.

In Japanese Patent Application Laid-Open Publication No. 2020-123847, sufficient consideration has not been made on a phenomenon that occurs in the standby state in which the charge unit and a power source are disconnected.

### SUMMARY

According to a first aspect of the present invention, there is provided a photoelectric conversion apparatus as specified in claim 1. Optional features of the first aspect are specified in claims 2 to 19. According to a second aspect of the present invention, there is provided a photoelectric conversion system as specified in claim 20. Optional features of the second aspect are specified in or derivable from claims 2 to 19. According to a third aspect of the present invention, there is provided a movable body as specified in claim 21. Optional features of the third aspect are specified in or derivable from claims 2 to 19.

The present invention is directed to providing a photoelectric conversion apparatus that addresses an issue that occurs in a standby state in which a charge unit and a power source are disconnected.

Further features of the present invention will become apparent from the following description of embodiments with reference to the attached drawings.

### BRIEF DESCRIPTION OF THE DRAWINGS

Fig. 1 is a diagram illustrating a configuration of a photoelectric conversion apparatus according to an embodiment.
Fig. 2 is a diagram illustrating an arrangement of a sensor substrate of the photoelectric conversion apparatus according to an embodiment.
Fig. 3 is a diagram illustrating a configuration of a circuit substrate of the photoelectric conversion apparatus according to an embodiment.
Fig. 4 is a block diagram illustrating one pixel of the sensor substrate and the circuit substrate according to an example of an embodiment.
Figs. 5A to 5C are schematic diagrams illustrating the driving of a pixel circuit of the photoelectric conversion apparatus according to an embodiment.
Fig. 6 illustrates a configuration example of a pixel circuit of a photoelectric conversion apparatus according to a first embodiment.
Fig. 7 is a diagram illustrating a relationship between a clock signal, a photon incidence timing, a voltage of a cathode terminal, and a current flowed by a voltage control unit according to an example and the first embodiment.
Fig. 8 is a diagram illustrating a relationship between a reverse current and a cathode voltage according to an example and the first embodiment.
Fig. 9 is a configuration diagram of a pixel circuit of a photoelectric conversion apparatus according to a first example.
Fig. 10 is a configuration diagram of a pixel circuit of a photoelectric conversion apparatus according to a second example.
Fig. 11 is a configuration diagram of a pixel circuit of a photoelectric conversion apparatus according to a third example.
Figs. 12A and 12B are diagrams illustrating an issue due to leak current according to a third Example.
Fig. 13 is a schematic plan view illustrating configurations of a charge unit, a waveform shaping unit, and a voltage control unit according to a third example.
Fig. 14 is a schematic cross-sectional view taken along a line X-X' in Fig. 13.
Figs. 15A to 15C are schematic plan views each illustrating a wiring layer included in a second wiring structure.
Fig. 16 is a configuration diagram of a pixel circuit of a photoelectric conversion apparatus according to a fourth example.
Fig. 17 is a configuration diagram of a pixel circuit of a photoelectric conversion apparatus according to a fifth example.
Fig. 18 is a diagram illustrating a relationship between a clock signal, a photon incidence timing, a voltage of a cathode terminal, and a voltage at node A according to the fifth example.
Fig. 19 is a schematic plan view illustrating configurations of an amplitude conversion unit and a voltage control unit according to the fifth example.
Fig. 20 is a schematic cross-sectional view taken along a line X-X' in Fig. 19.
Fig. 21 is a configuration diagram of a pixel circuit of a photoelectric conversion apparatus according to a sixth example.
Fig. 22 is a configuration diagram of a pixel circuit of a photoelectric conversion apparatus according to a seventh example.
Fig. 23 is a block diagram illustrating one pixel of a sensor substrate, a first circuit substrate, and a second circuit substrate of the photoelectric conversion apparatus according to a second embodiment.
Fig. 24 is a functional block diagram of a photoelectric conversion system according to a third embodiment.
Fig. 25A is a diagram illustrating a photoelectric conversion system according to a fourth embodiment, and Fig. 25B is a diagram illustrating a configuration of a movable body.
Fig. 26 is a functional block diagram of a photoelectric conversion system according to a fifth embodiment.
Fig. 27 is a functional block diagram of a photoelectric conversion system according to a sixth embodiment.
Figs. 28A and 28B are diagrams of eyeglasses (smart glass) as an example of a photoelectric conversion system according to a seventh embodiment.
Figs. 29A and 28B are diagrams illustrating an example of an electronic device on which a photoelectric conversion apparatus according to an eighth embodiment is mounted.
Fig. 30 is a functional block diagram of a photoelectric conversion system according to a ninth embodiment.
Figs. 31A to 31C are functional block diagrams of a photoelectric conversion system according to a tenth embodiment.

### DESCRIPTION OF THE EMBODIMENTS

The embodiments described below are intended to embody the technical idea of the present invention and how to carry it into effect and should be considered to not limit the present invention. The size and positional relationship of members shown in the drawings may be exaggerated for clarity of description. In the following description, the same components are denoted by the same reference numerals, and the redundant description may be omitted.

In the following description, terms indicating specific directions and positions (for example, "upper", "lower", "right", "left", and other terms including these terms) are used as necessary, and these terms are used to facilitate understanding of the embodiments with reference to the drawings, and the technical scope of the present invention is not limited by the meanings of these terms.

In the specification, a planar view refers to a view in a direction perpendicular to a light incident surface of a semiconductor layer. A cross-sectional view refers to a view from a surface in a direction perpendicular to the light incident surface. In a case where the light incident surface of the semiconductor layer is a rough surface when viewed microscopically, a planar view is defined based on the light incident surface of the semiconductor layer when viewed macroscopically.

In the following descriptions, the anode of an avalanche photodiode (APD) is at a fixed potential, and a signal is extracted from the cathode side. Thus, a semiconductor region of a first conductivity type in which charges having the same polarity as that of signal charges are majority carriers is an N-type semiconductor region, and a semiconductor region of a second conductivity type in which charges having a polarity different from that of the signal charges are majority carriers is a P-type semiconductor region.

Even in a case where the cathode of the APD is at a fixed potential, and a signal is extracted from the anode side, the present invention holds true. In this case, a semiconductor region of the first conductivity type in which charges having the same polarity as that of signal charges are majority carriers is a P-type semiconductor region, and a semiconductor region of the second conductivity type in which charges having a polarity different from that of the signal charges are majority carriers is an N-type semiconductor region. While a description is given below of a case where one of the nodes of the APD is at a fixed potential, the potentials of both nodes may be variable.

In this specification, the term "impurity concentration" means a net impurity concentration obtained by subtracting compensation by impurities of the opposite conductivity type. That is, an "impurity concentration" refers to a net doping concentration. A region where a P-type additive impurity concentration is higher than an N-type additive impurity concentration is a P-type semiconductor region. Conversely, a region where an N-type additive impurity concentration is higher than a P-type additive impurity concentration is an N-type semiconductor region.

In the following embodiments, connection between elements of a circuit may be described, and even when another element is interposed between elements of interest, the elements of interest are regarded as being connected to each other unless otherwise specified. For example, an element A is connected to one node of a capacitor C having a plurality of nodes, and an element B is connected to a different node of the capacitor C. Even in such a case, the elements A and B are regarded as being connected to each other unless otherwise specified.

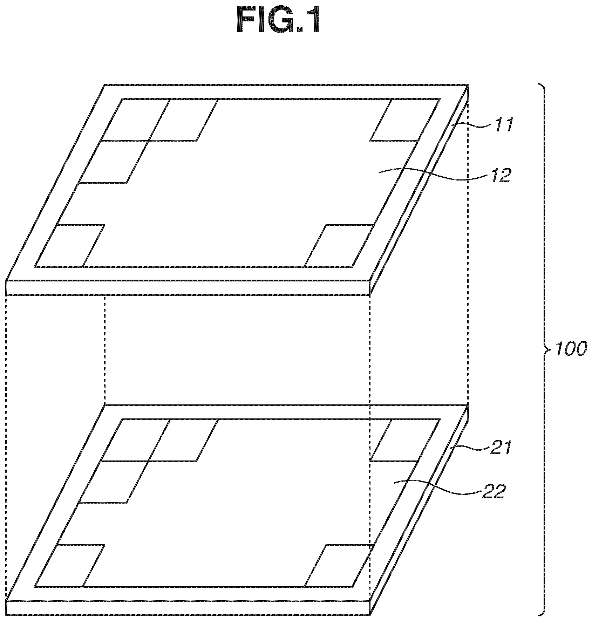

Fig. 1 is a diagram illustrating a configuration of a photoelectric conversion apparatus 100 of the stacking type. The photoelectric conversion apparatus 100 includes two substrates stacked one on another and electrically connected to each other. The sensor substrate 11 includes a first semiconductor layer including a photoelectric conversion unit 102 to be described below, and a first wiring structure. The circuit substrate 21 includes a second semiconductor layer including a circuit, such as a signal processing unit 103 to be described below, and a second wiring structure. The photoelectric conversion apparatus 100 includes the second semiconductor layer, the second wiring structure, the first wiring structure, and the first semiconductor layer that are stacked in this order. The photoelectric conversion apparatus to be described in each embodiment is a back-illuminated photoelectric conversion apparatus in which light enters from a second surface of the first semiconductor layer, and a circuit substrate is arranged on a first surface of the first semiconductor layer.

Hereinafter, the sensor substrate 11 and the circuit substrate 21 will be described as singulated chips, but the sensor substrate 11 and the circuit substrate 21 are not limited to chips. For example, each substrate may be a wafer. Each substrate may be singulated after being stacked in a wafer state, or may be singulated into chips from the wafer state and then jointed by stacking the chips.

A pixel region 12 is on the sensor substrate 11, and a circuit region 22 in which signals detected in the pixel region 12 are processed is on the circuit substrate 21.

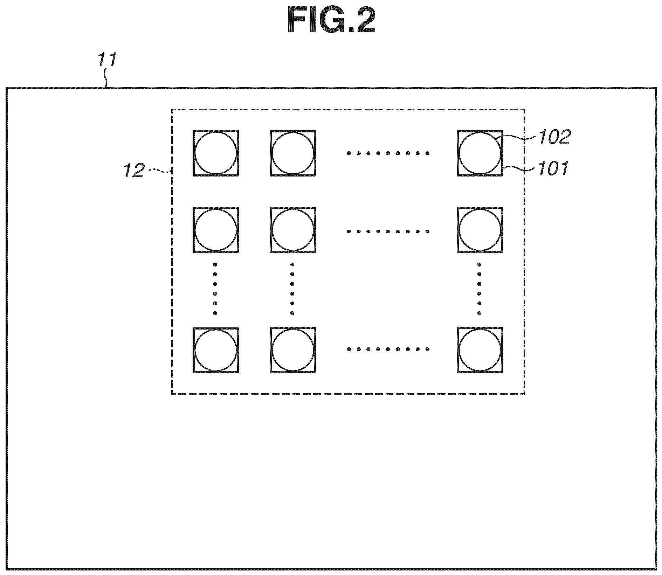

Fig. 2 is a diagram illustrating an arrangement example of the sensor substrate 11. Pixels 101 each including the photoelectric conversion unit 102 including an APD are arranged in a two-dimensional array in a planar view, and form the pixel region 12.

Typically, the pixel 101 is a pixel for forming an image. In a case where the pixel 101 is used in a time of flight (TOF) sensor, an image may not to be formed. In other words, the pixel 101 may be a pixel for measuring a light reached time and for measuring a light amount.

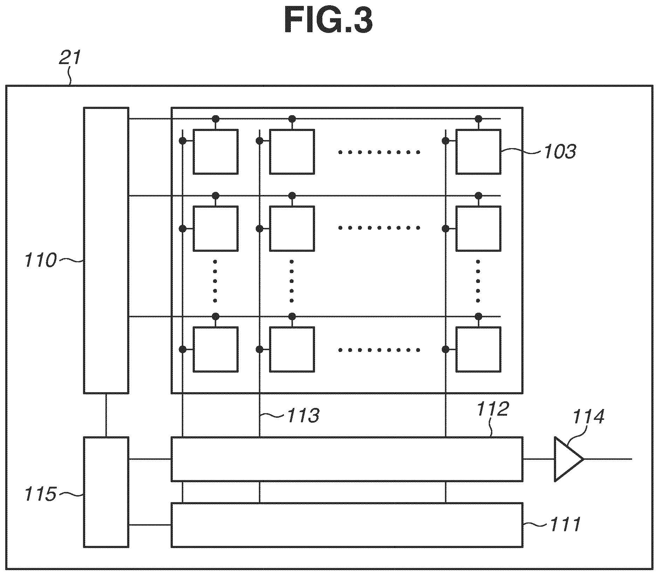

Fig. 3 is a configuration diagram of the circuit substrate 21. The circuit substrate 21 includes the signal processing unit 103 that processes signals output from the photoelectric conversion unit 102 illustrated in Fig. 2, a readout circuit 112, a control pulse generation unit 115, a horizontal scanning circuit unit 111, a signal line 113, and a vertical scanning circuit unit 110.

The photoelectric conversion unit 102 illustrated in Fig. 2 and the signal processing unit 103 illustrated in Fig. 3 are electrically connected to each other via a connection line disposed in each pixel.

The vertical scanning circuit unit 110 receives a control pulse supplied from the control pulse generation unit 115, and supplies the control pulse to each pixel. A logic circuit, such as a shift register or an address decoder, is used as the vertical scanning circuit unit 110.

A signal output from the photoelectric conversion unit 102 of a pixel is processed by the signal processing unit 103. A counter and a memory are disposed in the signal processing unit 103, and a digital value is stored in the memory.

The horizontal scanning circuit unit 111 inputs, to the signal processing unit 103, a control pulse for a sequential selection of each column to read out a signal from the memory of each pixel that stores a digital signal.

A signal is output to the signal line 113 from the signal processing unit 103 of a pixel on a selected column that has been selected by the vertical scanning circuit unit 110.

The signal output to the signal line 113 is output via an output circuit 114 to a recording unit or a signal processing unit that is disposed outside the photoelectric conversion apparatus 100.

In Fig. 2, photoelectric conversion units in a pixel region may be one-dimensionally arrayed.

The function of the signal processing unit may be not included in each of all photoelectric conversion units. For example, one signal processing unit may be shared by a plurality of photoelectric conversion units, and signal processing may be sequentially performed.

As illustrated in Figs. 2 and 3, a plurality of signal processing units 103 is arranged in a region overlapping the pixel region 12 in a planar view. The vertical scanning circuit unit 110, the horizontal scanning circuit unit 111, the readout circuit 112, the output circuit 114, and the control pulse generation unit 115 are arranged in such a manner as to overlap, in a planar view, a region defined by the ends of the sensor substrate 11 and the ends of the pixel region 12. In other words, the sensor substrate 11 includes the pixel region 12, and a non-pixel region arranged around the pixel region 12. The vertical scanning circuit unit 110, the horizontal scanning circuit unit 111, the readout circuit 112, output circuit 114, and the control pulse generation unit 115 are arranged in a region overlapping the non-pixel region in a planar view.

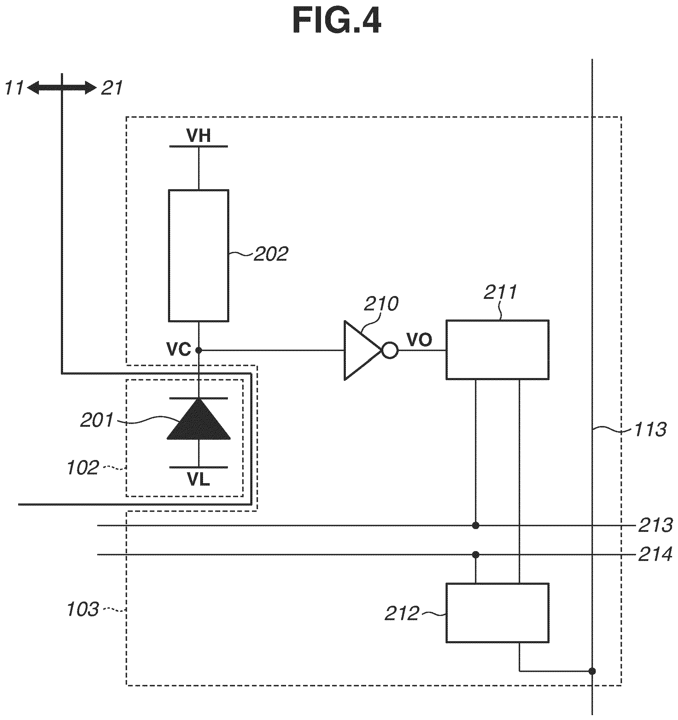

Fig. 4 illustrates an example of a block diagram including an equivalent circuit of the pixel illustrated in Figs. 2 and 3. Fig. 4 is a block diagram illustrating a pixel including a general APD.

In Fig. 4, the photoelectric conversion unit 102 including an APD 201 is disposed on the sensor substrate 11, and other members are disposed on the circuit substrate 21.

The APD 201 generates a charge pair corresponding to incident light, by photoelectric conversion. The APD 201 includes a first terminal and a second terminal, a first power source is connected to the first terminal, and a second power source is connected to the second terminal. In Fig. 4, the first terminal of the APD 201 is a cathode, and the second terminal is an anode. A voltage VL is supplied from the second power source to the anode of the APD 201. A voltage VH higher than the voltage VL supplied to the anode is supplied from the first power source to the cathode of the APD 201. A reverse bias voltage which causes the APD 201 to perform an avalanche multiplication operation is supplied to the anode and the cathode of the APD 201. In a state in which such voltages are supplied, charges generated by incident light cause avalanche multiplication, and an avalanche current is generated.

In a case where the reverse bias voltage is supplied, an APD is operated in Geiger mode or Linear mode. In Geiger mode, an APD is operated with an anode-cathode potential difference that is larger than a breakdown voltage. In Linear mode, an APD is operated with an anode-cathode potential difference that is near a breakdown voltage, or with a voltage difference equal to or smaller than the breakdown voltage.

An APD operated in Geiger mode will be referred to as a single photon avalanche photodiode (SPAD). For example, the voltage VL is -30 V and the voltage VH is 1 V to 3 V. The APD 201 may be operated in Linear mode, or may be operated in Geiger mode.

A quench element 202 serving as a charge unit is connected to the APD 201 and a power source that supplies the voltage VH. The quench element 202 functions as a load circuit (quench circuit) when a signal is multiplied by avalanche multiplication, and has a function of suppressing avalanche multiplication by reducing a voltage to be supplied to the APD 201 (quench operation). The quench element 202 also has a function of returning a voltage to be supplied to the APD 201, to the voltage VH by flowing a current by an amount corresponding to a voltage drop caused by the quench operation (recharge operation). In this manner, the charge unit has a function of controlling the voltage of the APD 201.

The signal processing unit 103 includes a waveform shaping unit 210, a counter circuit 211, and a selection circuit 212.

In this specification, the signal processing unit 103 is not particularly limited as long as the signal processing unit 103includes any of the waveform shaping unit 210, the counter circuit 211, and the selection circuit 212.

The waveform shaping unit 210 shapes a potential change of the cathode of the APD 201 that has been obtained at the time of photon detection and outputs a pulse signal. An inverter circuit is used as the waveform shaping unit 210, for example. Fig. 4 illustrates an example in which one inverter is used as the waveform shaping unit 210, but a circuit in which a plurality of inverters is connected in series may be used, or another circuit having a waveform shaping effect may be used.

The counter circuit 211 counts the number of pulse signals (the number of times) output from the waveform shaping unit 210, and stores a count value. When a control pulse pRES is supplied via a drive line 213, the number of pulse signals that is stored in the counter circuit 211 is reset.

A control pulse pSEL is supplied to the selection circuit 212 from the vertical scanning circuit unit 110 illustrated in Fig. 3, via a drive line 214 illustrated in Fig. 4 (not illustrated in Fig. 3), and electric connection and separation between the counter circuit 211 and the signal line 113 are switched. The selection circuit 212 includes a buffer circuit for outputting a signal, for example.

Electric connection may be switched by a switch, such as a transistor disposed between the quench element 202 and the APD 201, or between the photoelectric conversion unit 102 and the signal processing unit 103. Similarly, the supply of the voltage VH or the voltage VL to be supplied to the photoelectric conversion unit 102 may be electrically switched using a switch, such as a transistor.

In the present embodiment, the configuration that uses the counter circuit 211 has been described. Alternatively, the photoelectric conversion apparatus 100 may acquire a pulse detection timing by using a time to digital converter (hereinafter, TDC) and a memory in place of the counter circuit 211. In this case, the generation timing of a pulse signal output from the waveform shaping unit 210 is converted into a digital signal by the TDC. To measure the timing of a pulse signal, a control pulse pREF (reference signal) is supplied via a drive line to the TDC from the vertical scanning circuit unit 110 illustrated in Fig. 1. Based on the control pulse pREF, the TDC acquires a digital signal indicating an input timing of a signal output from each pixel via the waveform shaping unit 210, as a relative time.

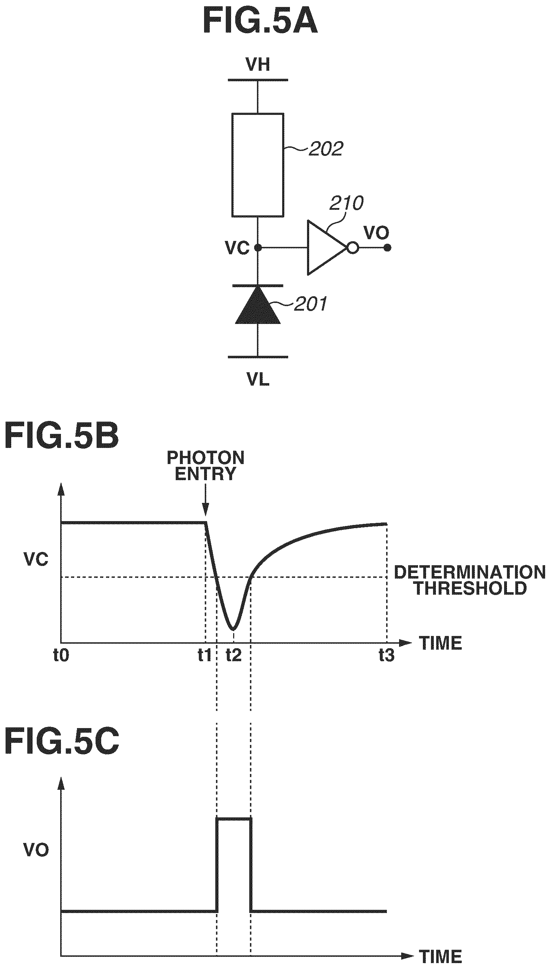

Figs. 5A to 5C are diagrams schematically illustrating a relationship between an operation of an APD and an output signal.

Fig. 5A is a diagram extracting the APD 201, the quench element 202, and the waveform shaping unit 210 that are illustrated in Fig. 4. In Fig. 5A, an input side of the waveform shaping unit 210 is regarded as VC and an output side is regarded as VO. Fig. 5B illustrates a waveform change at VC in Fig. 5A, and 5C illustrates a waveform change at VO in Fig. 5A.

During a period from a time t0 to a time t1, a potential difference VH-VL is applied to the APD 201 in Fig. 5A. In response to a photon entering the APD 201 at the time t1, avalanche multiplication occurs in the APD 201, an avalanche multiplication current flows to the quench element 202, and a voltage at VC drops. After a further increase in a voltage drop amount and a decrease in a potential difference applied to the APD 201, avalanche multiplication of the APD 201 stops at a time t2. During a period from the time t2 to a time t3, a current compensating for the voltage drop from the voltage VL flows to VC, and the potential level at VC is statically settled at the original potential level at the time t3. In this process, an output waveform portion exceeding a certain threshold value at VC is subjected to waveform shaping by the waveform shaping unit 210, and output as a signal at VO.

The arrangement of the signal lines 113, and the arrangement of the readout circuit 112 and the output circuit 114 are not limited to those illustrated in Fig. 3. For example, the signal lines 113 may be extended in a row direction, and the readout circuit 112 may be disposed at the extended ends of the signal lines 113.

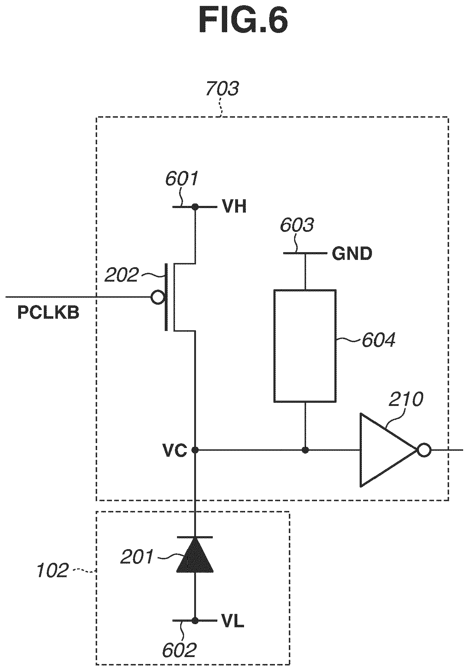

A photoelectric conversion apparatus according to a first embodiment will be described with reference to Figs. 6 to 8.

Fig. 6 illustrates the photoelectric conversion unit 102 including the APD 201 having the cathode (first terminal) and the anode (second terminal), and a part of a signal processing unit 703. The cathode of the APD 201 is connected to a first power source 601 via the quench element 202 serving as the charge unit. The waveform shaping unit 210 is connected to the cathode of the APD 201. The cathode of the APD 201 is connected with a third power source 603 via a voltage control unit (clipping unit) 604. The voltage control unit 604 controls a voltage of the cathode in accordance with the voltage of the cathode.

For example, the voltage control unit 604 controls the voltage of the cathode to reduce a drop of the voltage of the cathode when the voltage of the cathode drops to a predetermined value. In Fig. 6, a voltage of the first power source 601 is denoted by VH, a voltage of a second power source 602 is denoted by VL, and a voltage of the third power source 603 is denoted by GND. The voltage GND of the third power source 603 is a voltage value between the voltage VH of the first power source 601 and the voltage VL of the second power source 602. Specifically, the voltage VH of the first power source 601 is 1.1 V, for example, the voltage VL of the second power source 602 is -30 V, for example, and the voltage GND of the third power source 603 is 0 V, for example. The voltage GND of the third power source 603 may be equal to the voltage VH of the first power source 601. In this case, the voltage VH of the first power source 601 is 1.1 V, for example, the voltage VL of the second power source 602 is -30 V, for example, and the voltage GND of the third power source 603 is 1.1 V, for example.

The quench element 202 includes a P-channel metal oxide semiconductor (PMOS) transistor, for example, and a clock signal PCLKB is input to the gate of the PMOS transistor. The clock signal PCLKB is input at a predetermined cycle, for example. In the present embodiment, the presence or absence of electric connection between the first power source 601 and the cathode of the APD 201 is switched by controlling on/off of the quench element 202 in accordance with the clock signal PCLKB input to the quench element 202.

One terminal of the voltage control unit 604 is connected to the cathode of the APD 201, and a different terminal is connected to the third power source 603. The voltage control unit 604 is connected to the cathode of the APD 201 and controls a cathode voltage VC of the APD 201. In response to the cathode voltage VC reaching a predetermined voltage, current flows to VC from the third power source 603. In Fig. 6, the voltage control unit 604 is connected to the cathode side of the APD 201, but as described below, the voltage control unit 604 may be connected to the anode side of the APD 201.

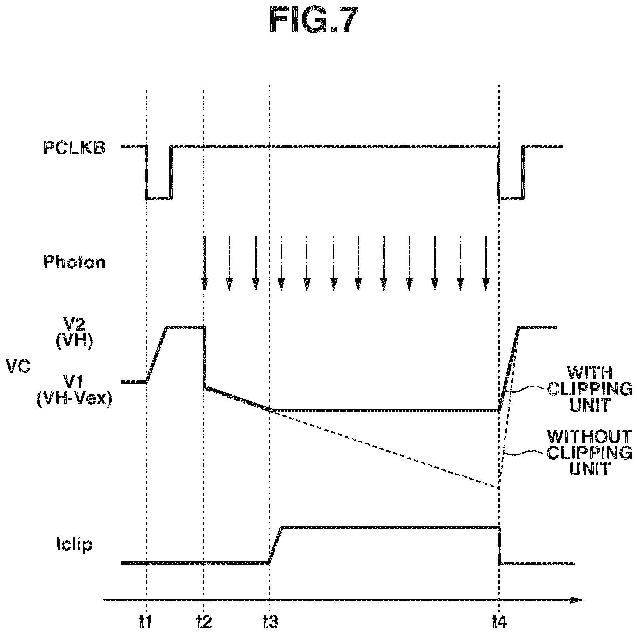

Fig. 7 is a diagram illustrating a relationship between the clock signal PCLKB, a photon entry timing, the cathode voltage VC, and current flowed by the voltage control unit 604. When the clock signal PCLKB changes to a low level at a time t1, the PMOS transistor of the quench element 202 is turned on, and the cathode voltage VC is charged from a potential V1 to a potential V2. The potential V2 corresponds to the voltage VH, which is a value of the voltage of the first power source 601. In this process, an applied voltage difference between the anode and the cathode of the APD 201 is Vbd (breakdown voltage) + Vex (excessive voltage). In this state, a voltage applied to the APD 201 is a voltage excessively applied by Vex with respect to the breakdown voltage, and avalanche multiplication can be performed in Geiger mode.

Then, when the clock signal PCLKB changes to a high level, the PMOS transistor of the quench element 202 is turned off, and a node to which a cathode terminal of the APD 201 is connected enters a floating state.

In response to a photon entering at the time t2, avalanche multiplication occurs in the APD 201, and the cathode voltage VC drops from the potential V2 to the potential V1. The potential V1 is a value smaller than the potential V2 by Vex, and at this time, the reverse bias voltage of the APD 201 drops to a voltage smaller than the breakdown voltage. The potential V2 is the voltage VH of the first power source 601, and the voltage VH is Vbd + Vex as described above. Thus, even when the cathode voltage VC drops to the potential V1 by an occurrence of avalanche multiplication, a voltage difference to be applied to the APD 201 can be maintained to a voltage difference equal to or larger than the breakdown voltage.

When the cathode voltage VC drops to a voltage smaller than the potential V1, a voltage difference to be applied to the APD 201 drops to a voltage difference smaller than the breakdown voltage.

Subsequently, in response to a photon entering at a time t2 or later, because the reverse bias voltage smaller than the breakdown voltage is applied to the APD 201, avalanche multiplication in Geiger mode does not occur. Meanwhile, the reverse bias voltage is applied to the APD 201 between the first power source 601 and the second power source 602, an electron-hole pair is generated by light emission, and reverse current is generated. Due to this reason, in a case without the voltage control unit 604, the cathode voltage VC continues to drop to a potential lower than the potential V 1, as indicated by a broken line in Fig. 7. When the clock signal PCLKB changes to the low level again at a time t4, the APD 201 is recharged and the cathode voltage of the APD 201 also returns to the potential V2.

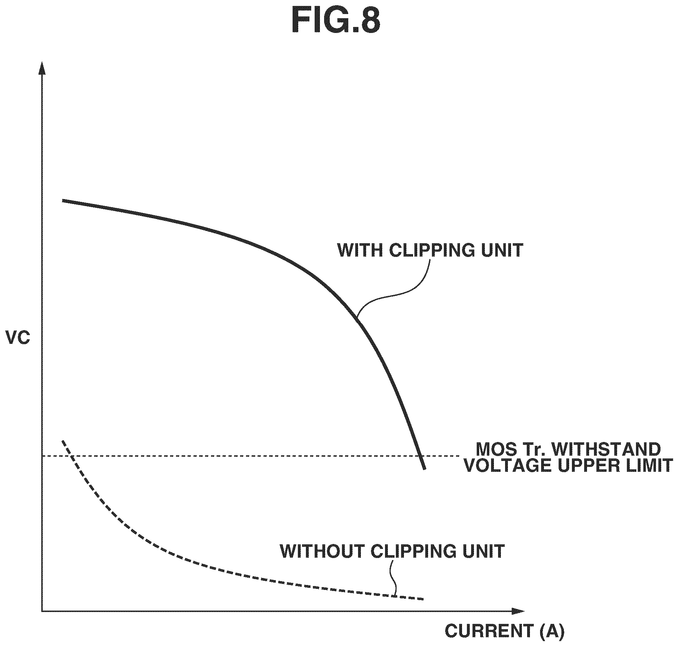

Fig. 8 is a diagram illustrating a relationship between the amplitude of a reverse current generated after the avalanche multiplication, and the cathode voltage VC. As illustrated in Fig. 8, when the reverse current flows, the cathode voltage VC drops. In a case without the voltage control unit 604, since the cathode voltage VC drops until the clock signal PCLKB changes to the low level, as indicated by a broken line in Fig. 8, the cathode voltage VC can exceed a withstand voltage of a MOS transistor.

In view of the foregoing, in the present embodiment, as illustrated in Fig. 6, the voltage control unit 604 is disposed. Even with the voltage control unit 604, the cathode voltage VC still drops due to light emitted after the avalanche multiplication. However, as illustrated in Fig. 7, in a case where the cathode voltage VC drops to a predetermined value at the time t3, the voltage control unit 604 controls the third power source 603 to flow current to the cathode of the APD 201. This can prevent the cathode voltage VC from dropping to a value exceeding predetermined value. This can prevent the cathode voltage VC from exceeding the withstand voltage of the MOS transistor, and a photoelectric conversion apparatus with high stability can be provided.

### (First Example)

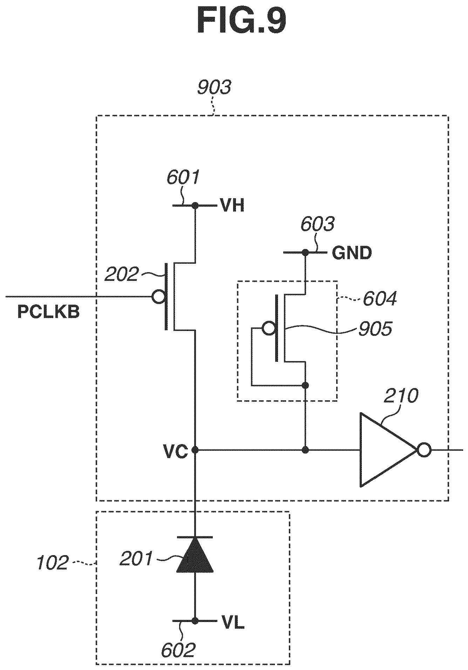

A first Example included in the above-described first embodiment will be described with reference to Fig. 9. Fig. 9 illustrates the photoelectric conversion unit 102 and a part of a signal processing unit 903. In this example, the voltage control unit 604 includes a PMOS transistor 905.

A source of the PMOS transistor 905 is connected to the third power source 603, and a drain of the PMOS transistor 905 is connected to the cathode of the APD 201. The drain of the PMOS transistor 905 is connected to a gate of the PMOS transistor 905. Due to photocurrent generated after the avalanche multiplication, the cathode voltage VC drops, and when the cathode voltage VC drops to a threshold value at which the PMOS transistor 905 enters an on state, current from the third power source 603 flows to the cathode of the APD 201. Because the cathode voltage VC can be increased by this current, the cathode voltage VC is prevented from dropping to a value exceeding a predetermined value and is prevented from exceeding the withstand voltage of the MOS transistor included in the quench element 202. With this configuration, a photoelectric conversion apparatus with high stability can be provided. Since the voltage control unit 604 can be implemented by a single PMOS transistor, the area occupation can be reduced.

The PMOS transistor 905 has a higher withstand voltage than that of the MOS transistor included in the quench element 202. For example, a film thickness of a gate oxide film of the PMOS transistor 905 is thicker than that of a gate oxide film of the MOS transistor included in the quench element 202. With this configuration, a withstand voltage is made higher. From the aspect of downsizing, the withstand voltage of the MOS transistor included in the quench element 202 may be fixed at a constant value or lower. On the other hand, because the PMOS transistor 905 can be designed relatively freely, the withstand voltage of the PMOS transistor 905 can be made higher.

### (Second Example)

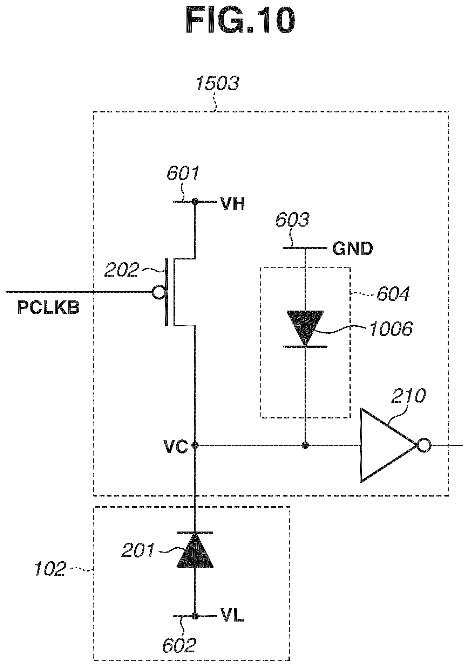

A second example included in the above-described first embodiment will be described with reference to Fig. 10. Fig. 10 illustrates the photoelectric conversion unit 102 and a part of a signal processing unit 1503.

In this example, the voltage control unit 604 includes a diode 1006. An anode of the diode 1006 is connected to the third power source 603, and a cathode of the diode 1006 is connected to the cathode of the APD 201. Due to photocurrent generated after the avalanche multiplication, the cathode voltage VC drops. For example, in response to the cathode voltage VC dropping to a voltage equal to or smaller than the voltage of the third power source 603, a forward bias voltage is applied to a diode to which a reverse bias voltage has been applied, which causes a current to flow to the cathode of the APD 201 from the third power source 603 via the diode 1006. Because the cathode voltage VC is increased by this current, the cathode voltage VC is prevented from dropping to a value exceeding a predetermined value, which leads to prevention of an excess of the withstand voltage of the MOS transistor. With this configuration, a photoelectric conversion apparatus with high stability can be provided.

### (Third Example)

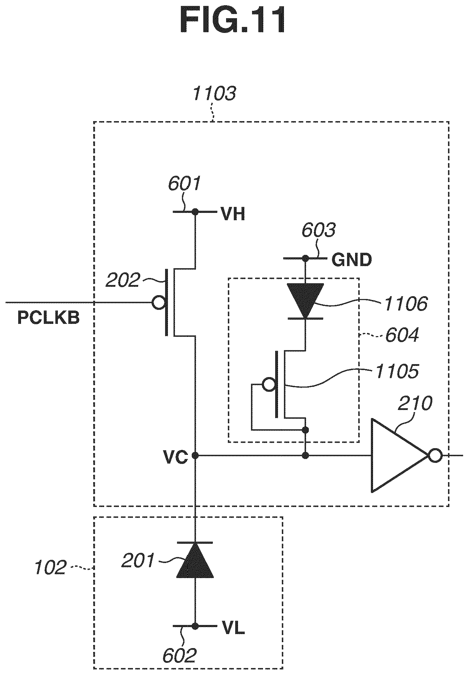

A third example included in the first embodiment will be described with reference to Fig. 11. Fig. 11 illustrates the photoelectric conversion unit 102 and a part of a signal processing unit 1103.

In this example, the voltage control unit 604 includes a diode 1106 and a PMOS transistor 1105. An anode of the diode 1106 is connected to the third power source 603, and a cathode of the diode 1106 is connected to a source of the PMOS transistor 1105. A drain of the PMOS transistor 1105 is connected to the cathode of the APD 201. The drain of the PMOS transistor 1105 is connected to a gate of the PMOS transistor 1105. Due to photocurrent generated after the avalanche multiplication, the cathode voltage VC drops, and the PMOS transistor 1105 enters the on state. Because a forward bias voltage is applied to the diode 1106 by the voltage of the third power source 603 and the voltage of the cathode of the APD 201, current flows from the third power source 603 toward the cathode of the APD 201. By this current, the cathode voltage VC is increased, and the cathode voltage VC is prevented from dropping to a value exceeding a predetermined value, which leads to prevention of an excess of the withstand voltage of the MOS transistor included in the quench element 202. A photoelectric conversion apparatus with high stability can be provided.

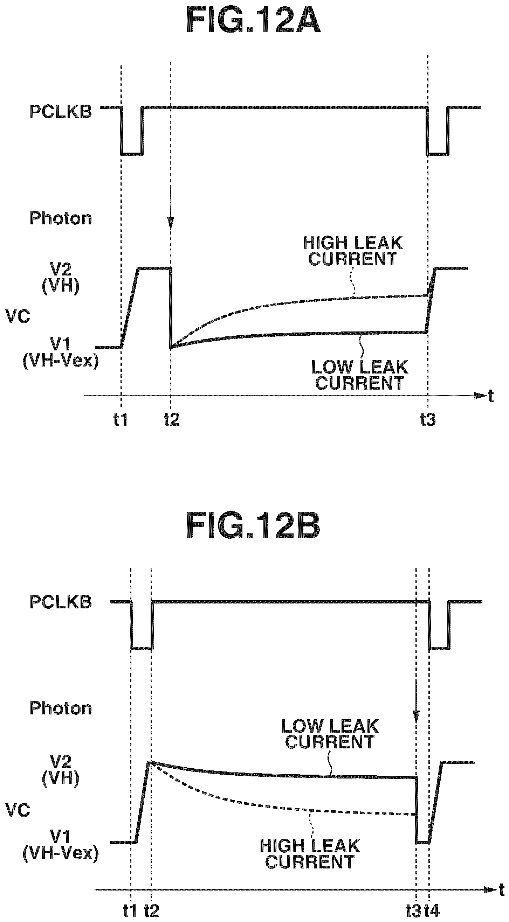

Generally, the leak current of a MOS transistor is higher than the leak current of a diode. For this reason, as compared with a case where a single PMOS transistor is disposed, which corresponds to the first example, in a case where a MOS transistor and a diode are used in combination, leak current which is generated in a current flow from the third power source 603 to the cathode of the APD 201 is reduced. An issue that arises in a case where leak current is high will be described with reference to Figs. 12A and 12B.

Fig. 12A is a diagram illustrating a case where a photon is detected immediately after recharge. In response to the clock signal PCLKB changing to the low level at a time t1, a PMOS transistor, which serves as the quench element 202, enters the on state, the cathode voltage VC rises due to the recharge, and the cathode voltage VC reaches a voltage value of the voltage V2 (for example, 1.1 V). In response to a photon entering at a time t2, the cathode voltage VC drops to a voltage value of the voltage V1 (for example, -1.4 V in a case where Vex is 2.5 V). Since leak current is high in a case with a single PMOS transistor, current flows from the third power source 603 to the cathode of the APD 201. In a case where the cathode voltage VC after the avalanche multiplication is a minus value (for example, -1.4 V), the voltage increases toward a plus direction, a reverse bias voltage equal to or larger than the breakdown voltage is applied to the APD 201, and the voltage reaches a voltage at which avalanche multiplication can occur. In this manner, under high illumination, during a period from the time t1 to a time t3 at which the clock signal PCLKB changes to the low level again, photons can be detected a plurality of times, which arises the issue of power consumption increase. On the other hand, by using a MOS transistor and a diode in combination, since leak current is low as indicated by a solid line in Fig. 12A, power consumption increase can be easily reduced.

Fig. 12B is a diagram illustrating a case where a photon is detected after a lapse of time from recharge. In response to the clock signal PCLKB changing to the low level at a time t1, a PMOS transistor, which serves as the quench element 202, enters the on state, the cathode voltage VC rises due to the recharge, and the cathode voltage VC becomes a voltage value of the potential V2 (for example, 1.1 V). After completion of the charge at a time t2, since leak current is high in a case with a single PMOS transistor, current flows from the third power source 603 to the cathode of the APD 201. In a case where the cathode voltage VC after charge is a plus value (for example, 1.1 V), the cathode voltage VC drops toward a minus direction. Consequently, the voltage Vex of the voltage corresponding Vbd + Vex that is applied to the APD 201 decreases, and an avalanche multiplication rate is decreased, which arises the issue of sensitivity reduction of the APD 201. On the other hand, by using a MOS transistor and a diode in combination, since leak current is low as indicated by a solid line in Fig. 12B, a voltage drop of the cathode voltage VC can be easily suppressed.

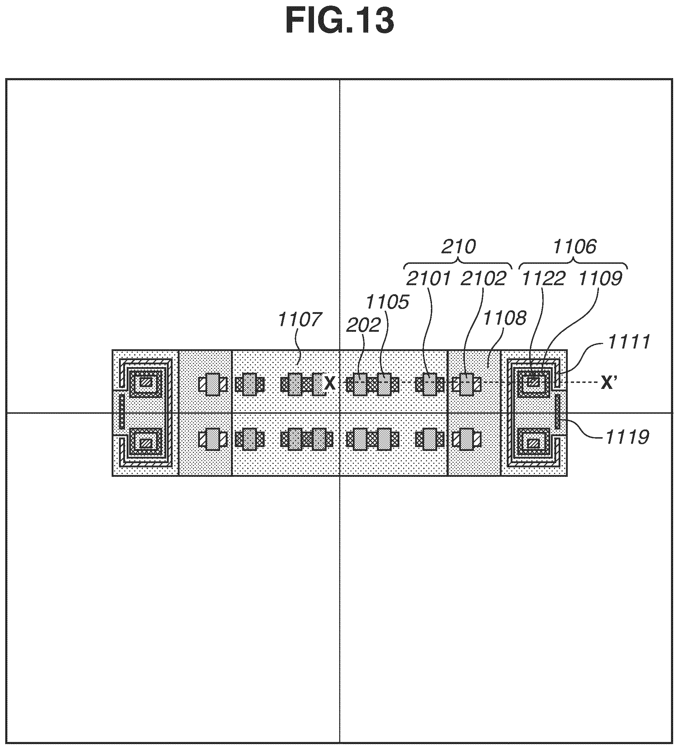

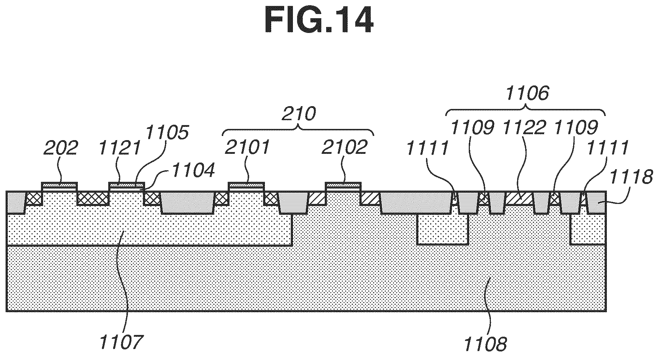

Fig. 13 is a schematic plan view illustrating configurations of the quench element 202 serving as the charge unit and the voltage control unit 604 according to the third example. Fig. 14 is a schematic cross-sectional view taken along a line X-X' in Fig. 13. Hereinafter, the charge unit and the voltage control unit 604 according to this example will be described with reference to Figs. 13 and 14, but the arrangement of the components is not limited to this.

Fig. 13 illustrates the quench elements 202 and the voltage control units 604 of four pixels.

The quench elements 202 of the four pixels are disposed near neighboring pixels. For example, a part of the quench elements 202 and the voltage control units 604 of the four pixels share a well region 1107. The well region 1107 is an N-type well region. In this example, the PMOS transistor of the quench element 202 and the PMOS transistor 1105 of the voltage control unit 604 are disposed in the N-type well region 1107. A PMOS transistor 2101 of the waveform shaping unit 210 is disposed in the well region 1107. As illustrated in Fig. 14, the well region 1107 is disposed in a P-type well region 1108.

An NMOS transistor 2102 of the waveform shaping unit 210 is disposed in the well region 1108. The waveform shaping unit 210 includes the PMOS transistor 2101 and the NMOS transistor 2102. The well region 1108 is disposed between P-type well regions 1107 in a planar view.

The diode 1106 of the voltage control unit 604 is disposed in the P-type well region 1107. In this example, the diode 1106 includes an N-type active region 1109 and a P-type active region 1122. Here, in this example, a well contact region is disposed between the NMOS transistor 2102 and the diode 1106. Specifically, an N-type well contact region 1111 and a P-type well contact region 1119 are disposed around the diode 1106. This configuration prevents a parasitic bipolar from operating between the NMOS transistor 2102 and the diode 1106. This configuration can form a bipolar transistor in which the N-type well contact region 1111 serves as a collector, the P-type active region 1122 serves as a base, and the N-type active region 1109 serves as an emitter. Furthermore, with the N-type well contact region 1111, operations of nearby transistors are less susceptible.

As illustrated in Fig. 14, a gate of each MOS transistor includes a gate electrode 1121 and a gate oxide film 1104. An element isolation region 1118 is disposed between the PMOS transistor 1105 and the PMOS transistor 2101. The element isolation region 1118 can include a shallow trench isolation (STI) or a deep trench isolation (DTI) including an insulating member, for example. The element isolation region 1118 may be a semiconductor isolation, or may include a semiconductor isolation and an insulating member.

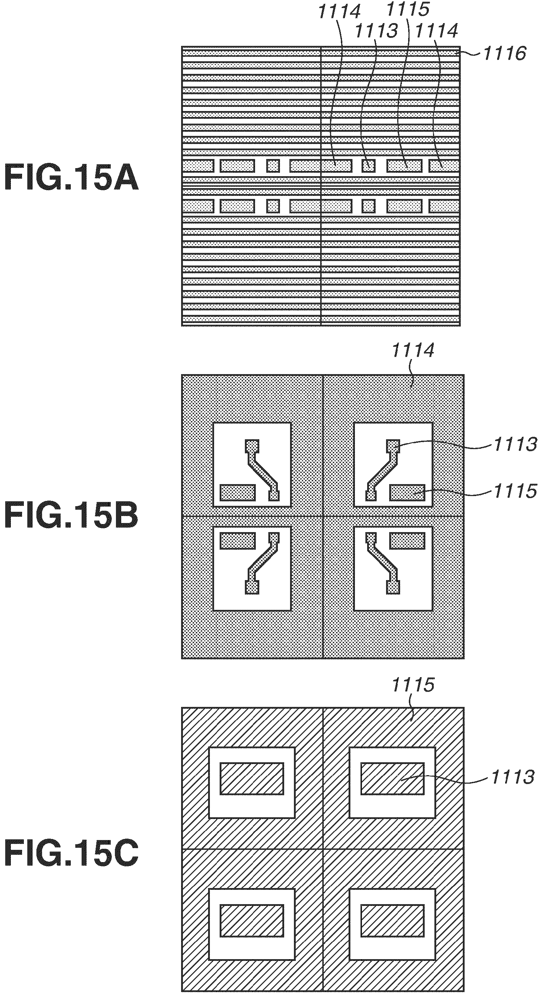

Figs. 15A to 15C are schematic plan views each illustrating a part of a wiring layer included in the second wiring structure. Fig. 15A illustrates a first wiring layer disposed close to the second semiconductor layer, Fig. 15B illustrates a second wiring layer disposed between the first wiring layer and the first wiring structure, and Fig. 15C illustrates a third wiring layer disposed between the second wiring layer and the first wiring structure. Another wiring layer may be disposed between the first wiring layer and the second semiconductor layer.

In the first wiring layer, a wiring pattern 1113, a wiring pattern 1114, a wiring pattern 1115, and a wiring pattern 1116 are disposed to correspond to the quench element 202, the voltage control unit 604, and the waveform shaping unit 210 in a planar view. The wiring pattern 1113 is a cathode wiring and is connected to the cathode of the APD 201. The wiring pattern 1114 also serves as a wiring that supplies power and supplies potential to the anode of the APD 201. The wiring pattern 1114 is connected to the MOS transistor of the quench element 202. The wiring pattern 1115 is a wiring that supplies a GND potential, and is connected to the anode of the diode 1106.

The wiring pattern 1116 is a signal wiring, and a signal output from the counter passes through the wiring pattern 1116.

The wiring pattern 1113 of the first wiring layer and the wiring pattern 1113 of the second wiring layer are connected. As illustrated in Fig. 15B, it is desirable that the wiring patterns 1113 are disposed obliquely to each other in a planar view, and kept away from the wiring pattern 1114 and the wiring pattern 1115 as far as possible.

This can reduce the coupling capacitance between the wiring pattern 1113 serving as a cathode wiring, and the wiring patterns 1114 and 1115 serving as power wirings. The amount of charges that is generated in recharging of the cathode voltage VC is determined by a cathode capacitance, including the capacitance of the cathode wiring, and an excess bias. The reduction in the amount of charges that is generated in recharging of the cathode potential leads to a reduction in power consumption.

The wiring pattern 1113 of the second wiring layer is connected to the wiring pattern 1113 of the third wiring layer illustrated in Fig. 15C. The wiring pattern 1115 of the second wiring layer is connected to the wiring pattern 1115 of the third wiring layer illustrated in Fig. 15C.

### (Fourth Example)

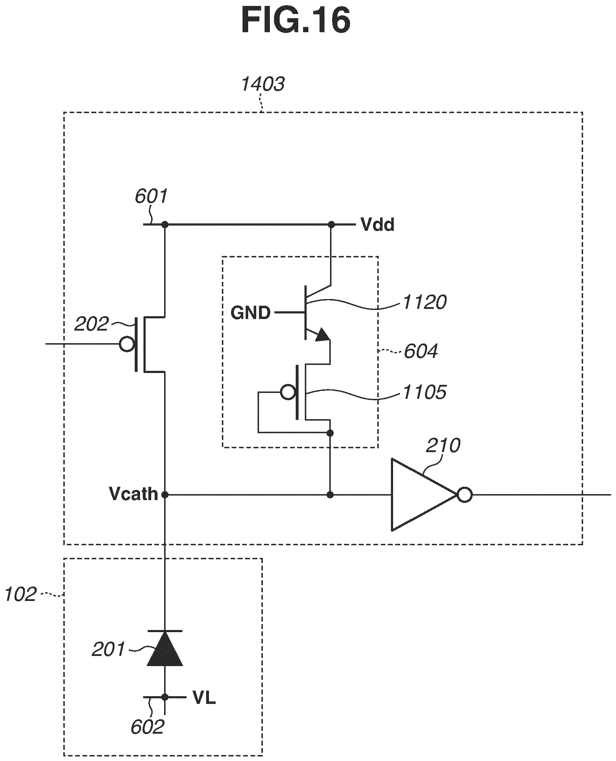

A fourth example included in the above-described first embodiment will be described with reference to Fig. 16. Fig. 16 illustrates the photoelectric conversion unit 102 and a part of a signal processing unit 1403.

In this example, the voltage control unit 604 includes a bipolar transistor 1120 and the PMOS transistor 1105. The voltage of the first power source 601 and the voltage of the third power source 603 are equal to each other.

A collector of the bipolar transistor 1120 is connected to the third power source 603. An emitter of the bipolar transistor 1120 is connected to the source of the PMOS transistor 1105. A GND voltage is supplied to a base of the bipolar transistor 1120. A voltage to be supplied to the base of the bipolar transistor 1120 is 1.1 V, for example.

A drain of the PMOS transistor 1105 is connected to the cathode of the APD 201. The drain of the PMOS transistor 1105 is connected to the gate of the PMOS transistor 1105. Due to photocurrent generated after the avalanche multiplication, the cathode voltage VC drops and the PMOS transistor 1105 enters the on state. Consequently, a forward bias voltage is applied to the diode 1106 by the voltage of the third power source 603 and the voltage of the cathode of the APD 201, current flows from the third power source 603 toward the cathode of the APD 201. By this current, the cathode voltage VC is increased, which leads to prevention of dropping of the cathode voltage VC to a value exceeding a predetermined value and prevention of an excess of the withstand voltage of the MOS transistor included in the quench element 202. With this configuration, a photoelectric conversion apparatus with high stability can be provided.

By amplifying current using the bipolar transistor 1120, the drop of the cathode voltage VC can be further suppressed. The bipolar transistor 1120 may be a parasitic bipolar.

### (Fifth Example)

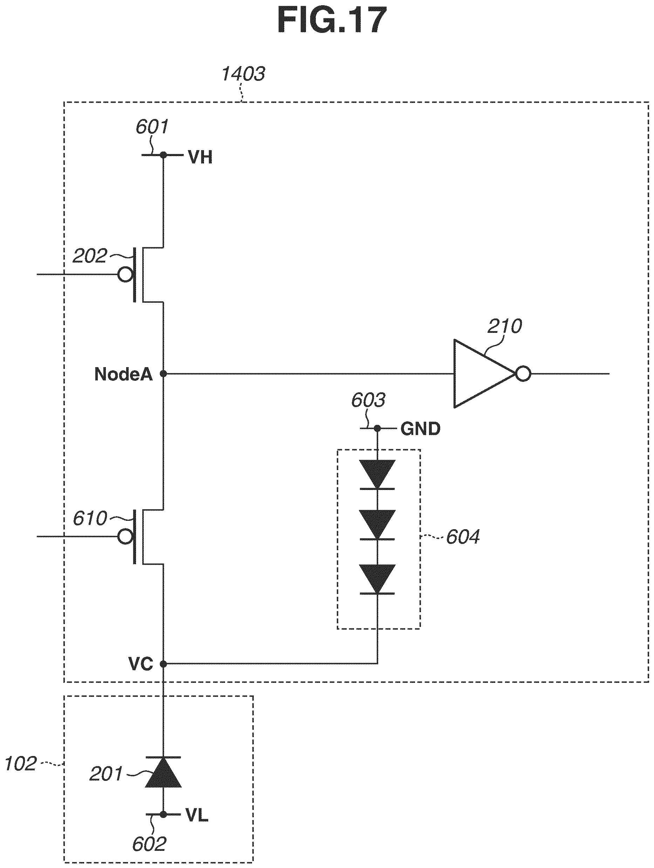

A fifth example included in the above-described first embodiment will be described with reference to Fig. 17. Fig. 17 illustrates the photoelectric conversion unit 102 and a part of a signal processing unit 1403.

In this example, the voltage control unit 604 includes a plurality of diodes. For example, the voltage control unit 604 can include three diodes. An amplitude conversion unit 610 is connected between the quench element 202 and the cathode of the APD 201. The amplitude conversion unit 610 can include a PMOS transistor, for example. The amplitude conversion unit 610 controls a voltage at a node NodeA in accordance with a gate voltage of the amplitude conversion unit 610. Because the amplitude of the cathode voltage VC (for example, 2.1 V) is applied between the source and the drain of the MOS transistor, the amplitude conversion unit 610 desirably uses a transistor with a high withstand voltage. For example, a transistor with a withstand voltage of 2.5 V is used. On the other hand, because withstand voltages of the quench element 202 and the waveform shaping unit 210 are not required to be so high, it is desirable to use a transistor with a low withstand voltage. For example, the quench element 202 and the waveform shaping unit 210 use transistors with a withstand voltage of 1.3 V.

The cathode of the APD 201 and the cathodes of the diodes are connected. Then, the three diodes are continuously connected. According to this example as well, dropping of the cathode voltage VC to a value exceeding a predetermined value is prevented, and an excess of the withstand voltage of the MOS transistor included in the quench element 202 is prevented. With this configuration, a photoelectric conversion apparatus with high stability can be provided. By three diodes being connected as in this example, as compared with the case of executing control by one diode, the control of the voltage of the cathode voltage VC is easier.

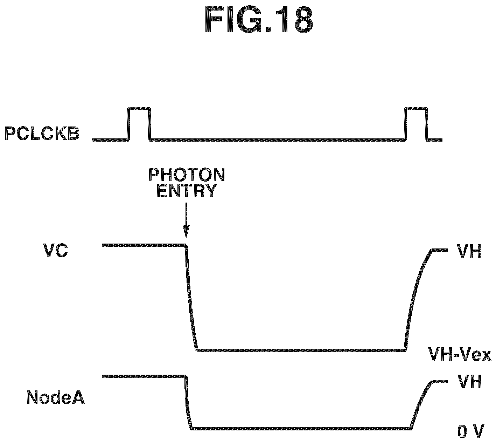

An operation in a case where the amplitude conversion unit 610 is disposed will be described with reference to Fig. 18. Fig. 18 is a diagram illustrating a clock signal, photon entry timing, the cathode voltage VC, and the node NodeA between the quench element 202 and the amplitude conversion unit 610. In response to entry of a photon and dropping of the cathode voltage VC, a voltage at the node NodeA also drops. In this process, the amplitude conversion unit 610 can convert an amplitude Vex of the cathode voltage VC into an amplitude (VH) of the node NodeA. With this configuration, low voltage transistors can be used as the quench element 202 and the waveform shaping unit 210, and a layout area can be made smaller.

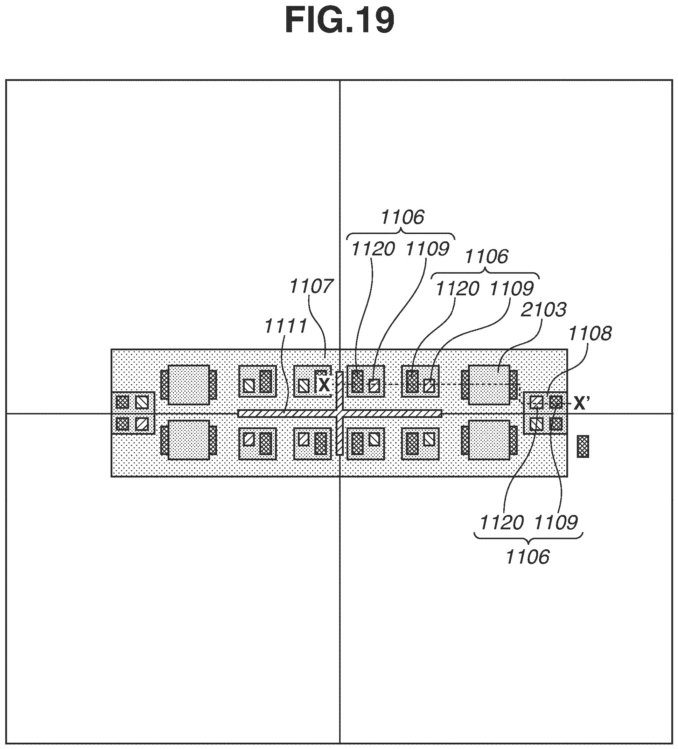

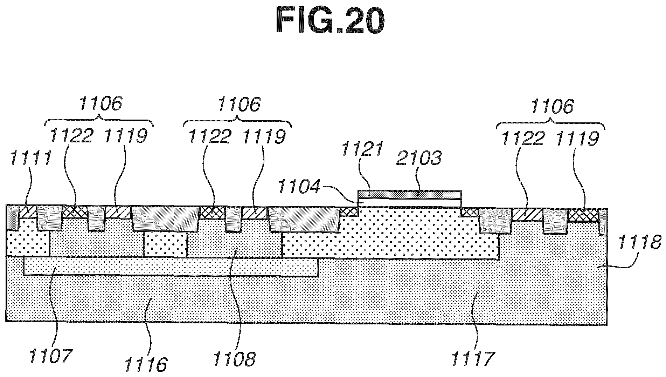

Fig. 19 is a schematic plan view illustrating configurations of the amplitude conversion unit 610 and the voltage control unit 604 according to this example, and Fig. 20 is a schematic cross-sectional view taken along a line X-X' in Fig. 19. In this example, the N-type well region 1107 and the P-type well region 1108 are disposed in a P-type substrate region 1117. A PMOS transistor 2103 included in the amplitude conversion unit 610 is disposed in an N-type well region 1107. The PMOS transistor 2103 is disposed between two diodes 1106 and one diode 1106.

Among the three diodes 1106, the center diode 1106 is a diode connected to VC in Fig. 17 (the cathode terminal of the APD 201). It is therefore desirable that the center diode 1106 is disposed adjacent to the PMOS transistor 2103. This reduces a cathode wiring capacitance and reduces power consumption. It is desirable that the diode 1106 disposed on the opposite side of the center diode 1106 with respect to the PMOS transistor 2103 is a diode connected to the third power source 603. Because a P-type substrate region can be shared with a nearby transistor, the layout area is reduced.

### (Sixth Example)

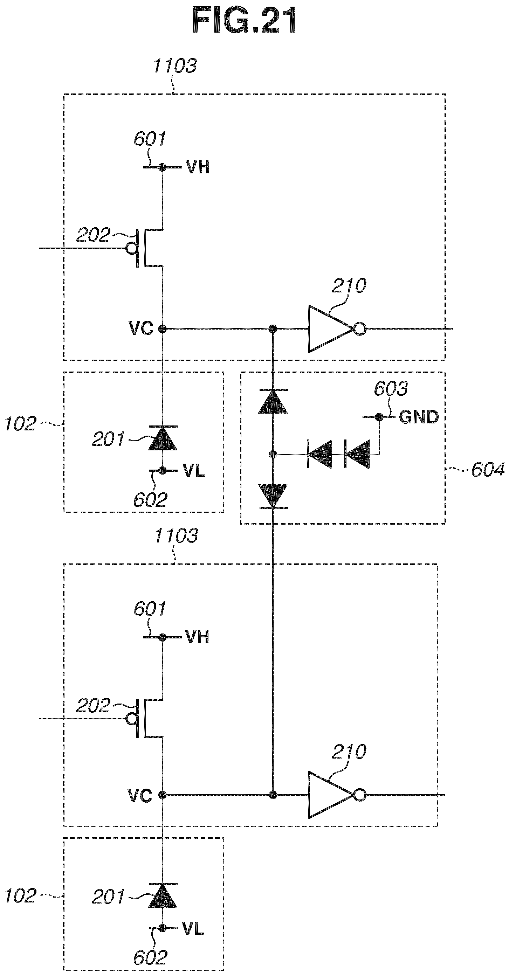

A sixth example included in the above-described first embodiment will be described with reference to Fig. 21.

In this example, a part of the voltage control unit 604 is shared by a plurality of APDs 201. the layout area is reduced.

As illustrated in Fig. 21, the voltage control unit 604 according to this example includes four diodes. Two diodes of the voltage control unit 604 that are connected to the respective cathode voltages VC of the APDs 201 perform a role to correctly detect signals from the APDs 201. Thus, a diode closest to the cathode voltage VC is disposed for each APD 201, and a subsequent diode is shared by a plurality of APDs 201.

While, in Fig. 21, a part of the voltage control unit 604 is shared by two APDs 201, the voltage control unit 604 may be shared by three or more APDs 201.

### (Seventh Example)

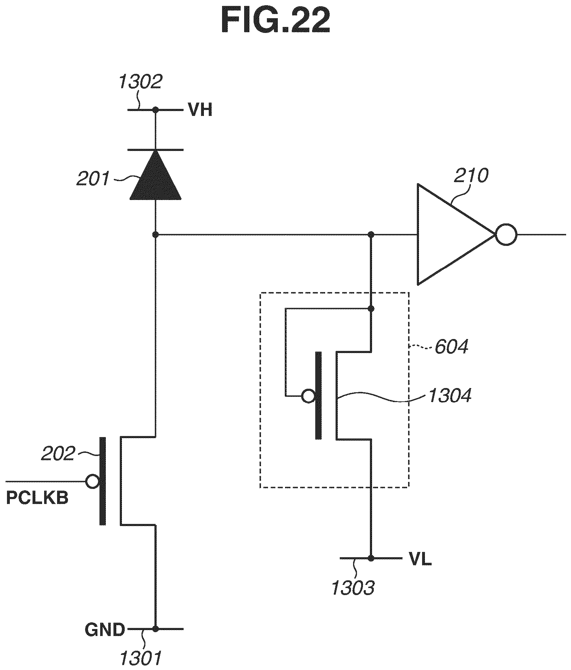

A seventh example is a modified example of the first to sixth examples, and this example will be described with reference to Fig. 22. In this example, the anode (first terminal) of the APD 201 is connected to a first power source 1301 via the quench element 202 serving as the charge unit. The cathode (second terminal) of the APD 201 is connected to a second power source 1302. An NMOS transistor 1304 which serves as the voltage control unit 604 is connected to the anode of the APD 201. Specifically, a source of the NMOS transistor 1304 is connected to the anode of the APD 201, and a drain of the NMOS transistor 1304 is connected to a third power source 1303. In Fig. 22, a voltage of the first power source 1301 is denoted by GND, a voltage of the second power source 1302 is denoted by VH, and a voltage of the third power source 1303 is denoted by VL. The voltage of the third power source 1303 is a voltage value between the voltage of the first power source 1301 and the voltage of the second power source 1302. Specifically, the voltage of the first power source 1301 is 0 V, for example, the voltage of the second power source 1302 is 30 V, for example, and the voltage of the third power source 1303 is 1.1 V, for example. The voltage of the third power source 1303 may be equal to the voltage of the first power source 1301. Specifically, the voltage of the first power source 1301 is 0 V, for example, the voltage of the second power source 1302 is 30 V, for example, and the voltage of the third power source 1303 is 0 V, for example.

When an anode voltage VA is increased by photocurrent generated after the avalanche multiplication, and the anode voltage VA increases to a threshold value at which the NMOS transistor 1304 enters the on state, current flows from the anode of the APD 201 to the third power source 1303. By this current, the anode voltage is decreased, which leads to prevention of an increase in the anode voltage VA to a value exceeding a predetermined value, and prevention of an excess of the withstand voltage of the MOS transistor. Thus, with this configuration, a photoelectric conversion apparatus with high stability can be provided. Since the voltage control unit 604 can be implemented by disposing a single NMOS transistor, the area can be reduced.

In the first to sixth examples, a terminal of an anode and a terminal of a cathode may be swapped as in this example.

### (Eighth Example)

An eighth example is a modified example of the first to seventh examples. In each example described above, the presence or absence of electric connection between the cathode of the APD 201 and the first power source is switched in accordance with a clock signal by using a MOS transistor which serves as the charge unit. The configuration is not limited to this, and the charge unit may be a resistor. A MOS transistor to which a clock signal is not input may be used as the charge unit. Specifically, passive recharge may be performed.

For example, in a case where an APD current under high illumination is higher than recharge current generated by the charge unit, a cathode potential sometimes exceeds a withstand voltage of a MOS transistor. Even in such a case, under high illumination, the voltage control unit 604 is used, and thus the withstand voltage of the MOS transistor is ensured.

In the above-described embodiment, the photoelectric conversion apparatus including two stacked layers has been described with reference to Figs. 1 to 22.

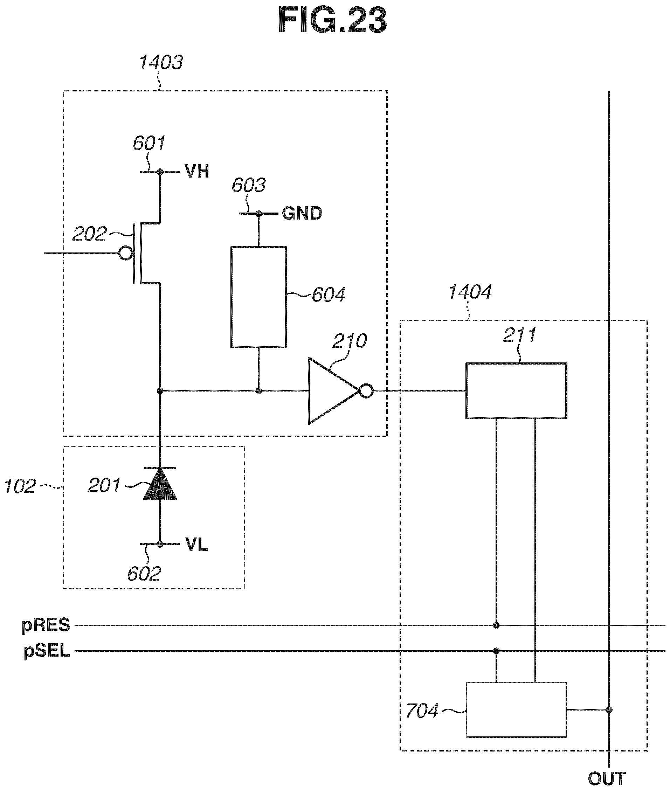

Specifically, the above-described embodiment is an example in which the photoelectric conversion unit 102 is disposed on the sensor substrate 11 serving as the first substrate, the signal processing unit 103 is disposed on the circuit substrate 21 serving as the second substrate, and the first substrate and the second substrate are stacked one on another. In a second embodiment, a photoelectric conversion apparatus in which a third substrate is also stacked in addition to the first substrate and the second substrate will be described with reference to Fig. 23. Fig. 23 illustrates the photoelectric conversion unit 102, a part of a signal processing unit 1403, and the other part of the signal processing unit 1404.

In Fig. 23, the photoelectric conversion unit 102 is arranged on a sensor substrate serving as the first substrate.

A first signal processing unit including the quench element 202, the voltage control unit 604, and the waveform shaping unit 210 are disposed on a first circuit substrate serving as the second substrate. Furthermore, a second signal processing unit including a counter circuit and a selection circuit are disposed on a second circuit substrate serving as the third substrate. Then, the first substrate, the second substrate, and the third substrate are stacked one on another.

The APD 201 has a large voltage change attributed to avalanche multiplication at the cathode or the anode. For this reason, as a MOS transistor included in the quench element 202 serving as the charge unit, an element (for example, MOS transistor) included in the voltage control unit 604, and an element (for example, MOS transistor) included in the waveform shaping unit 210, MOS transistors with a high withstand voltage are used. On the other hand, an output from the waveform shaping unit 210 is a digital signal with a pulse waveform, and a MOS transistor with a high withstand voltage may not be used. Meanwhile, in a signal processing circuit subsequent to the waveform shaping unit 210, lower voltage can be achieved by using a MOS transistor with a low withstand voltage, which leads to achievement of lower power consumption. Using a MOS transistor with a low withstand voltage leads to downsizing of the transistor, which also leads to achievement of space saving. For example, the thickness of a gate oxide film of a MOS transistor with a high withstand voltage is thicker than the thickness of a gate oxide film of a MOS transistor with a low withstand voltage. The channel length of a MOS transistor with a high withstand voltage is longer than the channel length of a MOS transistor with a low withstand voltage. Regarding the configurations of the first substrate and the second substrate, the configurations in each example described in the first embodiment can be employed.

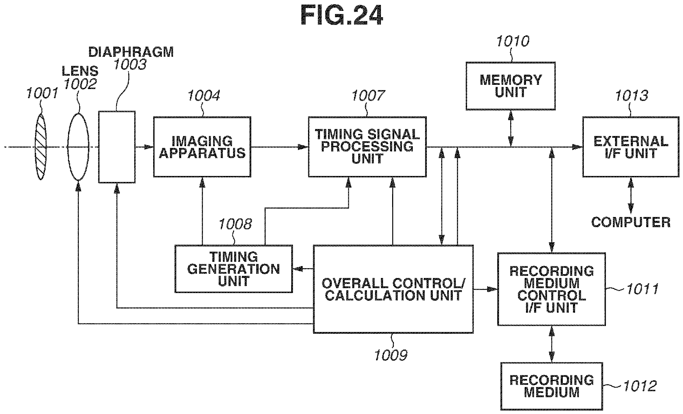

With reference to Fig. 24, a photoelectric conversion system according to a third embodiment is described. Fig. 24 is a block diagram illustrating a general configuration of the photoelectric conversion system according to the present embodiment.

The photoelectric conversion apparatus described in each of the first and second embodiments is applicable to various photoelectric conversion systems. Examples of the various photoelectric conversion systems include a digital still camera, a digital camcorder, a monitoring camera, a copying machine, a fax, a mobile phone, an in-vehicle camera, and an observation satellite. The various photoelectric conversion systems also include a camera module including an optical system, such as a lens and an imaging apparatus. Fig. 24 illustrates a block diagram of a digital still camera as one of these examples.

The photoelectric conversion system illustrated in Fig. 24 includes an imaging apparatus 1004, which is an example of the photoelectric conversion apparatus, and a lens 1002 that forms an optical image of a subject on the imaging apparatus 1004. The photoelectric conversion system further includes a diaphragm 1003 for varying an amount of light passing through the lens 1002, and a barrier 1001 for protecting the lens 1002. The lens 1002 and the diaphragm 1003 serves as an optical system that collects light onto the imaging apparatus 1004. The imaging apparatus 1004 is the photoelectric conversion apparatus according to any of the above-described embodiments and converts the optical image formed by the lens 1002 into an electric signal.

The photoelectric conversion system further includes a signal processing unit 1007 serving as an image generation unit that processes an output signal output from the imaging apparatus 1004, to generate an image. The signal processing unit 1007 performs an operation of performing various types of correction and compression as necessary and outputting image data. The signal processing unit 1007 may be formed on a semiconductor substrate in which the imaging apparatus 1004 is disposed, or may be formed on a semiconductor substrate different from the imaging apparatus 1004.

The photoelectric conversion system further includes a memory unit 1010 for temporarily storing image data, and an external interface unit (external I/F unit) 1013 for communicating with an external computer. The photoelectric conversion system further includes a recording medium 1012, such as a semiconductor memory, for recording therein or reading therefrom captured data, and a recording medium control interface unit (recording medium control I/F unit) 1011 for recording or reading image data in or from the recording medium 1012. The recording medium 1012 may be built into the photoelectric conversion system or may be attachable to and detachable from the photoelectric conversion system.

Further, the photoelectric conversion system according to the present embodiment includes an overall control/calculation unit 1009 that performs various calculations and controls the entire operation of the digital still camera, and a signal generation unit 1008 that outputs various timing signals to the imaging apparatus 1004 and the signal processing unit 1007. The timing signals may be input from outside, and the photoelectric conversion system may be required to include at least the imaging apparatus 1004 and the signal processing unit 1007 that processes an output signal output from the imaging apparatus 1004.

The imaging apparatus 1004 outputs an imaging signal to the signal processing unit 1007. The signal processing unit 1007 performs predetermined signal processing on the imaging signal output from the imaging apparatus 1004 and outputs image data. The signal processing unit 1007 generates an image using the imaging signal.

As described above, according to the present embodiment, it is possible to achieve a photoelectric conversion system to which the photoelectric conversion apparatus (the imaging apparatus) according to any of the above-described embodiments is applied.

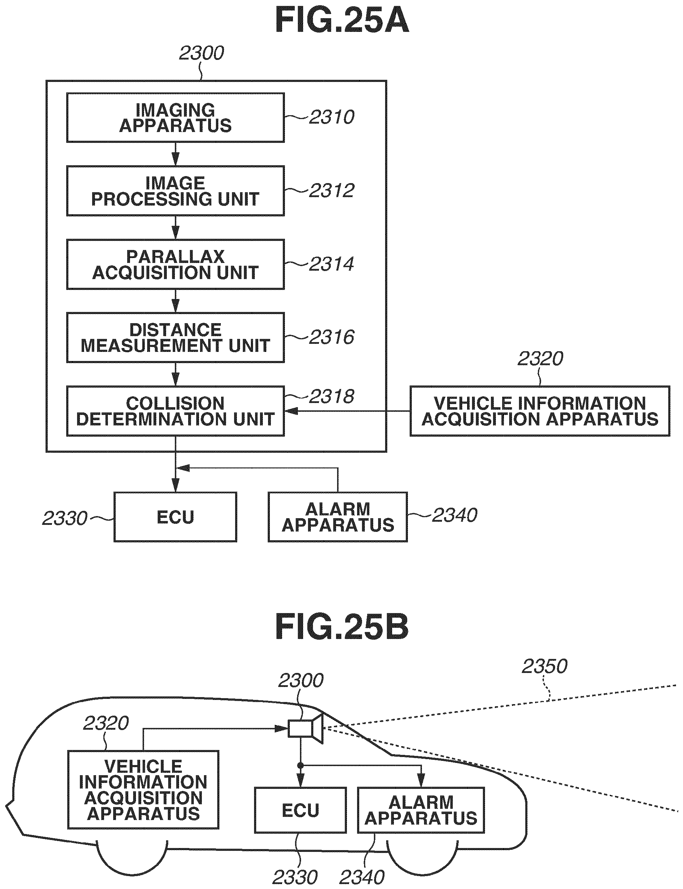

With reference to Figs. 25A and 25B, a photoelectric conversion system and a movable body according to a fourth embodiment are described. Figs. 25A and 25B are diagrams illustrating the configurations of the photoelectric conversion system and the movable body according to the present embodiment.

Fig. 25A illustrates an example of a photoelectric conversion system regarding an in-vehicle camera. A photoelectric conversion system 2300 includes an imaging apparatus 2310. The imaging apparatus 2310 is the photoelectric conversion apparatus according to any of the above-described embodiments. The photoelectric conversion system 2300 includes an image processing unit 2312 that performs image processing on a plurality of pieces of image data acquired by the imaging apparatus 2310, and a parallax acquisition unit 2314 that calculates a parallax (phase difference between parallax images) from the plurality of pieces of image data acquired by the photoelectric conversion system 2300. The photoelectric conversion system 2300 further includes a distance measurement unit 2316 that measures a distance from a target object based on the calculated parallax, and a collision determination unit 2318 that determines whether there is a possibility of a collision, based on the calculated distance. The parallax acquisition unit 2314 and the distance measurement unit 2316 are examples of a distance information acquisition unit that acquires distance information regarding the distance from a target object. That is, the distance information is information regarding the parallax, the amount of defocus, and the distance from the target object. Any of these pieces of distance information may be used by the collision determination unit 2318 to determine the possibility of a collision. The distance information acquisition unit may be achieved by exclusively designed hardware, or may be achieved by a software module.

Alternatively, the distance information acquisition unit may be achieved by a field-programmable gate array (FPGA) or an application-specific integrated circuit (ASIC), or may be achieved by the combination of these.

The photoelectric conversion system 2300 is connected to a vehicle information acquisition apparatus 2320 and can acquire vehicle information, such as a vehicle speed, a yaw rate, and a steering angle. The photoelectric conversion system 2300 is also connected to a control electronic control unit (ECU) 2330 that is a control unit that produces a braking force in the vehicle based on a determination result of the collision determination unit 2318. The photoelectric conversion system 2300 is also connected to an alarm apparatus 2340 that gives an alarm to a driver based on a determination result of the collision determination unit 2318. For example, if there is a high possibility of a collision as the determination result of the collision determination unit 2318, the control ECU 2330 performs braking, releasing an accelerator, or suppressing engine output, to control the vehicle to avoid a collision and reduce damage. The alarm apparatus 2340 warns a user by setting off an alarm such as a sound, displaying alarm information on a screen of an automotive navigation system, or imparting a vibration to a seat belt or the steering.

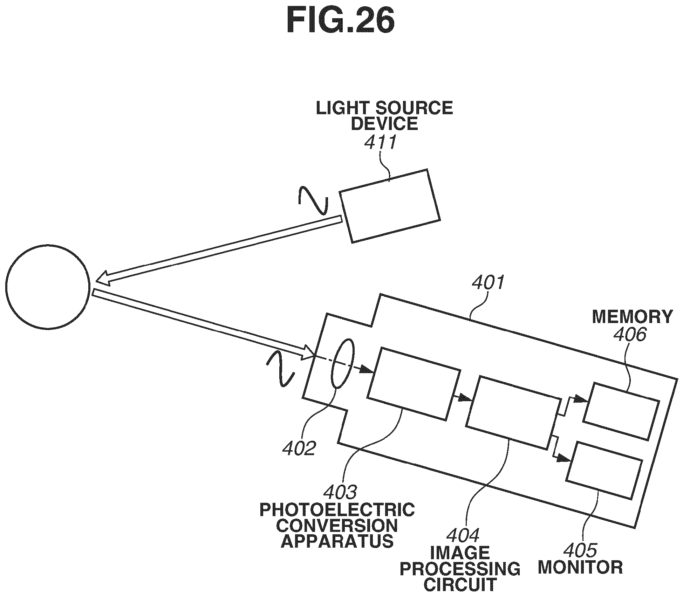

In the present embodiment, the photoelectric conversion system 2300 captures the periphery, such as the front direction or the rear direction, of the vehicle. Fig. 26B illustrates the photoelectric conversion system 2300 in a case where the photoelectric conversion system 2300 captures the front direction of the vehicle (an imaging range 2350). The vehicle information acquisition apparatus 2320 sends an instruction to the photoelectric conversion system 2300 or the imaging apparatus 2310. With this configuration, the accuracy of distance measurement can be further improved.

In the above description, an example has been described where a vehicle is controlled to avoid colliding with another vehicle. Alternatively, the present embodiment is also applicable to control for autonomous driving to follow another vehicle or control for autonomous driving to avoid a deviation from a lane. Furthermore, the photoelectric conversion system can be applied not only to a vehicle such as an automobile but also to a movable body (a moving apparatus), such as a vessel, an aircraft, or an industrial robot. Moreover, in addition to a movable body, the photoelectric conversion system can be applied to a device extensively using object recognition, such as an intelligent transportation system (ITS).

With reference to Fig. 26, a photoelectric conversion system according to a fifth embodiment is described. Fig. 26 is a block diagram illustrating an example of the configuration of a distance image sensor that includes the photoelectric conversion system according to the present embodiment.

As illustrated in Fig. 26, a distance image sensor 401 includes an optical system 402, a photoelectric conversion apparatus 403, an image processing circuit 404, a monitor 405, and a memory 406. Then, the distance image sensor 401 acquires a distance image corresponding to a distance from a subject by receiving light (modulated light or pulsed light) that has been projected from a light source device 411 toward the subject and reflected from the surface of the subject.

The optical system 402 includes one or more lenses and forms an image on a light-receiving surface (a sensor unit) of the photoelectric conversion apparatus 403 by guiding image light (incident light) from the subject to the photoelectric conversion apparatus 403.

As the photoelectric conversion apparatus 403, the photoelectric conversion apparatus according to each of the above-described embodiments is applied, and a distance signal indicating the distance obtained from a received light signal output from the photoelectric conversion apparatus 403 is supplied to the image processing circuit 404.

The image processing circuit 404 performs image processing to construct a distance image based on the distance signal supplied from the photoelectric conversion apparatus 403. Then, the distance image (image data) obtained by the image processing is supplied to and displayed on the monitor 405 or is supplied to and stored (recorded) in the memory 406.

Application of the above-described photoelectric conversion apparatus to the distance image sensor 401 having the above-describe configuration leads to achievement of acquiring a more accurate distance image, for example, in accordance with the improved characteristics of pixels.

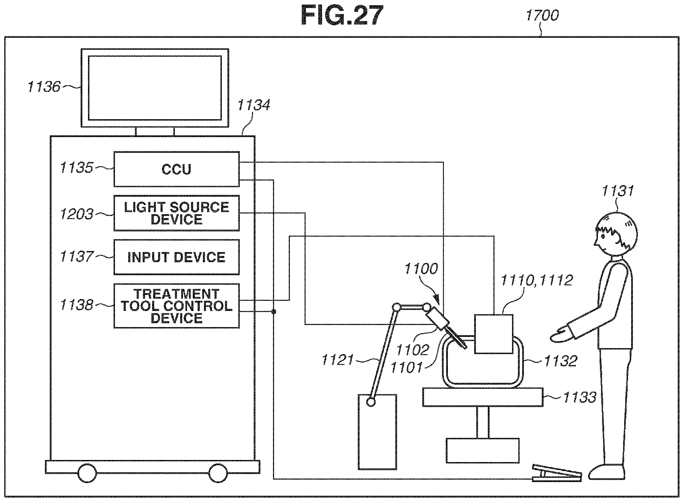

With reference to Fig. 27, a photoelectric conversion system according to a sixth embodiment is described. Fig. 27 is a diagram illustrating an example of the general configuration of an endoscopic operation system that is the photoelectric conversion system according to the present embodiment.

Fig. 27 illustrates the state where a user (doctor) 1131 performs a surgery on a patient 1132 on a patient bed 1133 using an endoscopic operation system 1700. As illustrated in Fig. 27, the endoscopic operation system 1700 includes an endoscope 1100, surgical tools 1110, and a cart 1134 equipped with various devices for an endoscopic operation.

The endoscope 1100 includes a lens barrel 1101 having a part to be inserted into a body cavity of a patient 1132 by a predetermined length from its front end, and a camera head 1102 connected to the base end of the lens barrel 1101. While, in the example illustrated in Fig. 27, the endoscope 1100 configured as a so-called rigid scope including the rigid lens barrel 1101, the endoscope 1100 may be configured as a so-called flexible scope including a flexible lens barrel.

An opening portion into which an objective lens is fitted is at the front end of the lens barrel 1101. A light source device 1203 is connected to the endoscope 1100. Light generated by the light source device 1203 is guided to the front end of the lens barrel 1101 by a light guide extended inside the lens barrel 1101, passes through the objective lens, and is emitted toward an observation target in the body cavity of the patient 1132. The endoscope 1100 may be a forward-viewing endoscope, or may be an oblique-viewing endoscope, or may be a side-viewing endoscope.

An optical system and a photoelectric conversion apparatus are disposed inside the camera head 1102, and reflected light (observation light) from the observation target is collected on the photoelectric conversion apparatus by the optical system. The observation light is photoelectrically converted by the photoelectric conversion apparatus, and an electric signal corresponding to the observation light, i.e., an image signal corresponding to an observation image, is generated. The photoelectric conversion apparatus according to each of the above-described embodiments can be used as the photoelectric conversion apparatus. The image signal is transmitted to a camera control unit (CCU) 1135 as RAW data.

The CCU 1135 includes a central processing unit (CPU) and a graphics processing unit (GPU), and comprehensively controls operations of the endoscope 1100 and a display device 1136. Further, the CCU 1135 receives an image signal from the camera head 1102 and performs various types of image processing for displaying an image based on the image signal, such as a development process (demosaic process), on the image signal.

Based on the control of the CCU 1135, the display device 1136 displays an image based on the image signal subjected to the image processing performed by the CCU 1135.

The light source device 1203 includes a light source, such as a light-emitting diode (LED), and supplies emission light for image capturing of an operation site to the endoscope 1100.

An input device 1137 is an input interface for an input to the endoscopic operation system 1700. A user can input various pieces of information and input an instruction to the endoscopic operation system 1700 via the input device 1137.

A treatment tool control device 1138 controls driving of energy treatment tools 1112 for cauterizing or incising tissue or sealing blood vessels.

The light source device 1203 that supplies emission light for capturing an operation site to the endoscope 1100 can include an LED, a laser light source, or a white light source configured by the combination of these, for example. In a case of a white light source including a combination of RGB laser light sources, the output intensity and an output timing of each color (each wavelength) can be controlled highly accuracy, and thus the white balance of a captured image can be adjusted in the light source device 1203. In this case, laser light is emitted from each of the RGB laser light sources onto the observation target in a time division manner, and the driving of an imaging element of the camera head 1102 is controlled in synchronization with the emission timing of the laser light, whereby an image corresponding to each of RGB can also be captured in a time division manner. According to this method, it is possible to obtain a color image without providing color filters in the imaging element.

The driving of the light source device 1203 may be controlled in such a manner that the intensity of light to be output from the light source device 1203 is changed every predetermined time. Images are acquired in a time division manner by controlling the driving of the image element of the camera head 1102 in synchronization with the change timing of the light intensity, and the images are combined, whereby a high dynamic range image without so-called blocked-up shadows and blown-out highlights is generated.

The light source device 1203 may also be configured to supply light in a predetermined wavelength band adapted to special light observation. In the special light observation, for example, the wavelength dependence of light absorption of body tissues is utilized. Specifically, light in a narrower band than emission light (i.e., white light) in normal observation is emitted to capture an image of a predetermined tissue, such as blood vessels in a superficial layer of a mucous membrane, with high contrast.

Alternatively, in the special light observation, fluorescence observation to obtain an image with fluorescent light generated by emitting excitation light may be performed. In the fluorescence observation, fluorescent light from the tissue of the body is observed by emitting excitation light onto the body tissue, or a fluorescent image is obtained by locally injecting reagent, such as indocyanine green (ICG), into a body tissue and emitting excitation light suitable for a fluorescence wavelength of the reagent onto the body tissue. The light source device 1203 can be configured to supply narrow-band light and/or excitation light adapted to such special light observation.

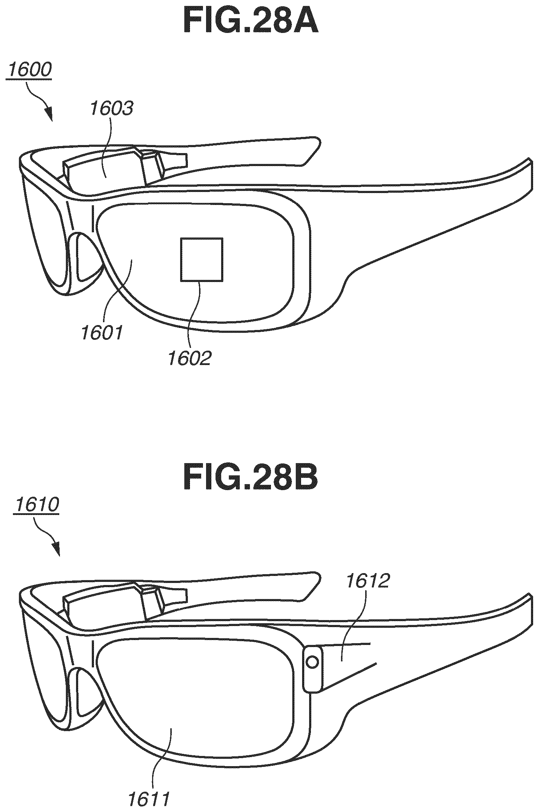

With reference to Figs. 28A and 28B, a photoelectric conversion system according to a seventh embodiment is described. Fig. 28A illustrates eyeglasses 1600 (smart glasses) that are the photoelectric conversion system according to the present embodiment. The eyeglasses 1600 include a photoelectric conversion apparatus 1602. The photoelectric conversion apparatus 1602 is the photoelectric conversion apparatus described in any of the above-described embodiments. On the back surface side of a lens 1601, a display device including a light emission device, such as an organic light emitting diode (OLED) or an LED, may be disposed. The number of photoelectric conversion apparatuses 1602 may be one or plural. In addition, a plurality of types of photoelectric conversion apparatuses 1602 may be used in combination. An arrangement position of the photoelectric conversion apparatus 1602 is not limited to the position illustrated in Fig. 28A.

The eyeglasses 1600 further include a control device 1603. The control device 1603 functions as a power source that supplies power to the photoelectric conversion apparatus 1602 and the above-described display device. The control device 1603 also controls operations of the photoelectric conversion apparatus 1602 and the display device. In the lens 1601, an optical system for condensing light to the photoelectric conversion apparatus 1602 is formed.

Fig. 28B illustrates eyeglasses 1610 (smart glasses) as an application example. The eyeglasses 1610 include a control device 1612, and the control device 1612 is equipped with a photoelectric conversion apparatus equivalent to the photoelectric conversion apparatus 1602, and a display device. In a lens 1611, an optical system for projecting light emitted from the photoelectric conversion apparatus and the display device in the control device 1612 is formed, and an image is projected onto the lens 1611. The control device 1612 functions as a power source that supplies power to the photoelectric conversion apparatus and the display device and controls operations of the photoelectric conversion apparatus and the display device. The control device 1612 may include a line of sight detection unit that detects a line of sight of a wearer (user). Infrared light may be used for the detection of a line of sight. An infrared light emission unit emits infrared light onto an eyeball of a user looking at a displayed image. An imaging unit including a light receiving element detects reflected light of the emitted infrared light that has been reflected from the eyeball, whereby a captured image of the eyeball is obtained. A reduction unit for reducing light from the infrared light emission unit to a display unit in a planar view is disposed so that a decline in image quality is suppressed.

A captured image of an eyeball obtained by the image capturing using infrared light is used to detect a line of sight of the user with respect to a displayed image. Any known method can be applied to the line of sight detection using a captured image of an eyeball. As an example, a line of sight detection method based on a Purkinje image obtained by reflection of irradiating light on a cornea can be used.

More specifically, a line of sight detection process based on the pupil center corneal reflection method is performed. A line of sight vector representing the direction (rotational angle) of an eyeball is calculated using the pupil center corneal reflection method, based on an image of a pupil and a Purkinje image that are included in a captured image of the eyeball, whereby a line of sight of the user is detected.

The display device of the present embodiment may include the photoelectric conversion apparatus including a light receiving element, and a displayed image on the display device may be controlled based on line of sight information on the user from the photoelectric conversion apparatus.

Specifically, in the display device, a first field of view region viewed by the user, and a second field of view region other than the first field of view region are determined based on the line of sight information. The first field of view region and the second field of view region may be determined by a control device of the display device, or the display device may receive the first field of view region and the second field of view region determined by an external control apparatus. In a display region of the display device, a display resolution of the first field of view region may be controlled to be higher than a display resolution of the second field of view region. More specifically, a resolution of the second field of view region may be set lower than a resolution of the first field of view region.

In addition, the display region includes a first display region and a second display region different from the first display region. Based on the line of sight information, a region with high priority may be determined from the first display region and the second display region. The first display region and the second display region may be determined by the control device of the display device, or the display device may receive the first display region and the second display region determined by an external control apparatus. Control may be performed in such a manner that a resolution of a region with high priority is controlled to be higher than a resolution of a region other than the region with high priority. In other words, a resolution of a region with relatively-low priority may be set to a low resolution.

Artificial intelligence (AI) may be used for determination of the first field of view region and the region with high priority. The AI may be a model configured to estimate an angle of a line of sight and a distance to a target object existing at the end of the line of sight, from an image of an eyeball by using training data including an image of the eyeball and a direction in which the eyeball in the image actually gives a gaze. An AI program may be included in the display device, the photoelectric conversion apparatus, or an external apparatus. In a case where an external apparatus includes an AI program, the AI program is transmitted to the display device via communication.

In a case where display control is performed based on line of sight detection, the present invention can be suitably applied to smart glasses further including a photoelectric conversion apparatus that captures an image of the outside. The smart glasses can display external information obtained by image capturing, in real time.

The above-described photoelectric conversion apparatus and photoelectric conversion system may be applied to an electronic device, such as a so-called smartphone and a tablet, for example.

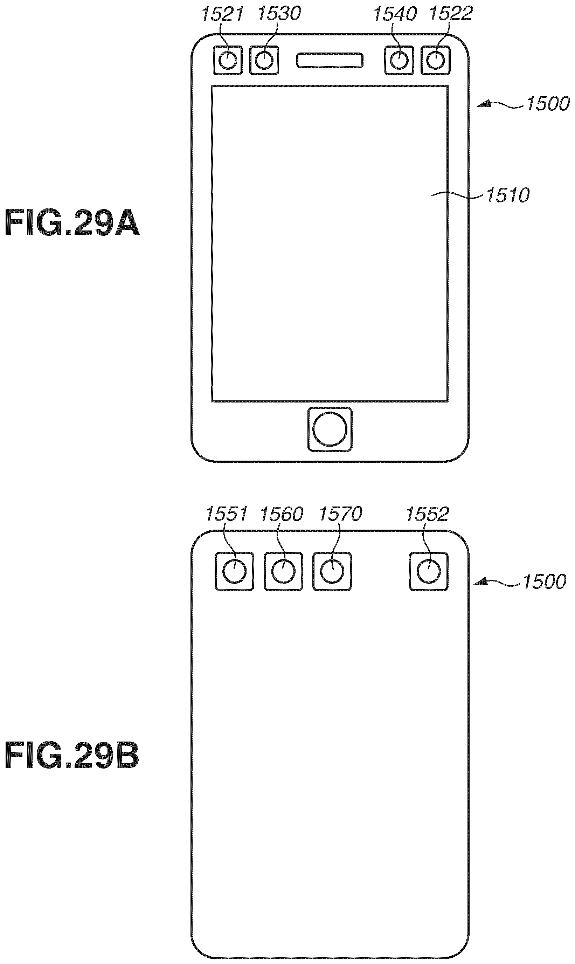

Figs. 29A and 29B are diagrams illustrating an example of an electronic device 1500 on which a photoelectric conversion apparatus is mounted. Fig. 29A illustrates a front surface of the electronic device 1500 and Fig. 29B illustrates a rear surface of the electronic device 1500.

As illustrated in Fig. 29A, a display 1510 for displaying an image is disposed at the center on the front surface of the electronic device 1500. Along an upper side of the front surface of the electronic device 1500, front cameras 1521 and 1522 in each of which a photoelectric conversion apparatus is used, an infrared ray (IR) light source 1530 that emits infrared light, and a visible light source 1540 that emits visible light are disposed.

As illustrated in Fig. 29B, along an upper side of the rear surface of the electronic device 1500, rear cameras 1551 and 1552 in each of which a photoelectric conversion apparatus is used, an IR light source 1560 that emits infrared light, and a visible light source 1570 that emits visible light are arranged.

In the electronic device 1500 having such a configuration, by applying the above-described photoelectric conversion apparatus, for example, a higher quality image is able to be captured. Aside from these, the photoelectric conversion apparatus can be applied to an electronic device, such as an infrared sensor, a distance measurement sensor that uses an active infrared light source, a security camera, or a personal or biometric authentication camera. The application leads to an increase in the accuracy and performance of these electronic devices.

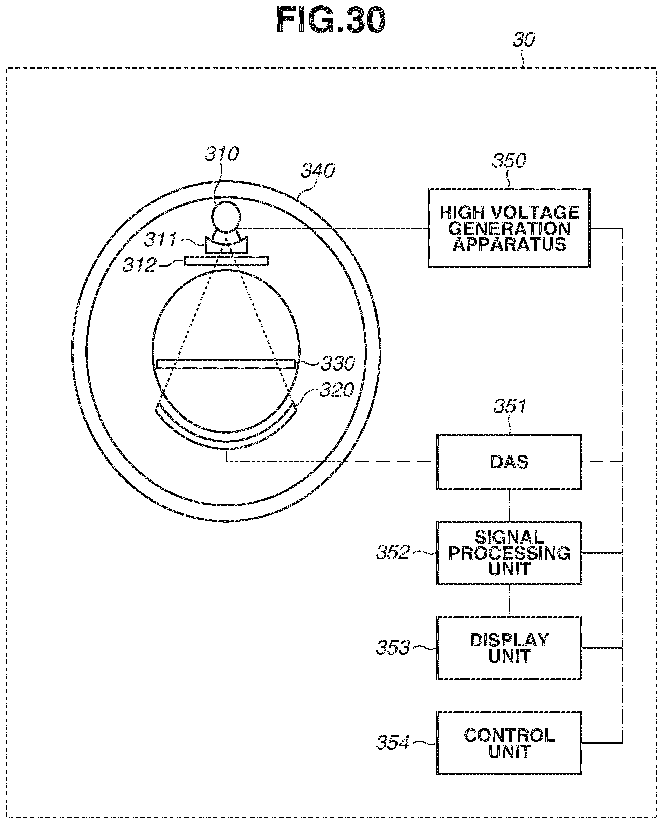

Fig. 30 is a block diagram of an X-ray computer tomography (CT) apparatus according to a ninth embodiment. The present embodiment can be applied to both of the first embodiment and the second embodiment. An X-ray CT apparatus 30 according to the present embodiment includes an X-ray generation unit 310, a wedge 311, a collimator 312, an X-ray detection unit 320, a top board 330, a rotation frame 340, and a high voltage generation apparatus 350. The X-ray CT apparatus 30 includes a data collection apparatus (data acquisition system: DAS) 351, a signal processing unit 352, a display unit 353, and a control unit 354.

The X-ray generation unit 310 includes a vacuum tube that generates X-rays, for example. High voltage and filament current from the high voltage generation apparatus 350 are supplied to the vacuum tube of the X-ray generation unit 310. By thermal electrons being emitted from a negative pole (filament) toward a positive pole (target), X-rays are generated.

The wedge 311 is a filter that adjusts an amount of X-rays emitted from the X-ray generation unit 310. The wedge 311 attenuates an X-ray amount in such a manner that X-rays emitted from the X-ray generation unit 310 to a subject have a predetermined distribution. The collimator 312 includes a lead plate that narrows down an emission range of X-rays that have passed through the wedge 311. The X-rays generated by the X-ray generation unit 310 are formed into a cone-beam shape via the collimator 312 and emitted to a subject on the top board 330.

The X-ray detection unit 320 includes a semiconductor apparatus in the first and second embodiments. The X-ray detection unit 320 detects X-rays that have been generated by the X-ray generation unit 310 and passed through the subject, and outputs a signal corresponding to an X-ray amount, together with the DAS 351.

The rotation frame 340 has an annular shape and is configured to be rotatable. In the rotation frame 340, the X-ray generation unit 310 (wedge 311, collimator 312) and the X-ray detection unit 320 are disposed to face each other. The X-ray generation unit 310 and the X-ray detection unit 320 are rotatable together with the rotation frame 340.

The high voltage generation apparatus 350 includes a booster circuit, and outputs high voltage to the X-ray generation unit 310. The DAS 351 includes an amplification circuit and an analog-to-digital (A/D) conversion circuit, and outputs a signal from the X-ray detection unit 320 to the signal processing unit 352 as digital data.

The signal processing unit 352 includes a central processing unit (CPU), a read only memory (ROM), and a random access memory (RAM), and executes image processing on digital data. The display unit 353 includes a flat-panel display device, and displays an X-ray image. The control unit 354 includes a CPU, a ROM, and a RAM, and controls entire operations of the X-ray CT apparatus 30.

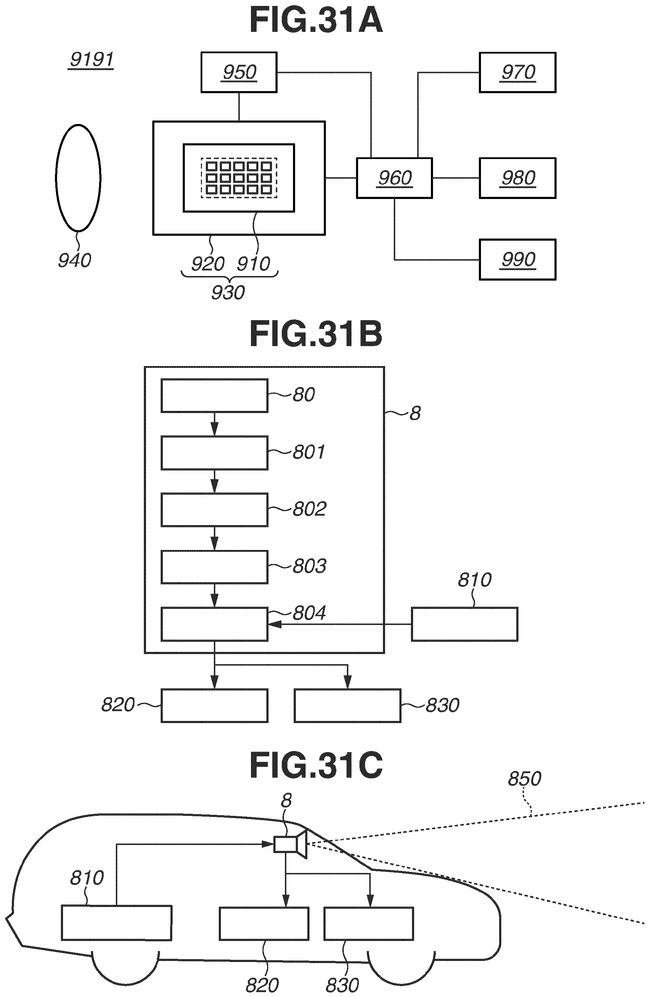

A tenth embodiment can be applied to both the first embodiment and the second embodiment. Fig. 31A is a schematic diagram illustrating a device 9191 including a semiconductor apparatus 930 according to the present embodiment.

As the semiconductor apparatus 930, the photoelectric conversion apparatus (imaging apparatus) according to each of the above-described embodiments can be used. The device 9191 including the semiconductor apparatus 930 will be described in detail. The semiconductor apparatus 930 includes a semiconductor device 910. In addition to the semiconductor device 910, the semiconductor apparatus 930 can includes a package 920 storing the semiconductor device 910. The package 920 includes a base member on which the semiconductor device 910 is fixed, and a lid member, such as glass facing the semiconductor device 910. The package 920 can further include a bonding member, such as a bonding wire or a bump that connects a terminal disposed in the base member and a terminal disposed in the semiconductor device 910.

The device 9191 includes at least any of an optical device 940, a control device 950, a processing device 960, a display device 970, a storage device 980, and a mechanical device 990. The optical device 940 supports for the semiconductor apparatus 930. The optical device 940 is a lens, a shutter, or a mirror, for example, and includes an optical system for guiding light to the semiconductor apparatus 930. The control device 950 controls the semiconductor apparatus 930. The control device 950 is a semiconductor apparatus, such as an ASIC, for example.

The processing device 960 processes a signal output from the semiconductor apparatus 930. The processing device 960 is a semiconductor apparatus, such as a CPU or an ASIC, for forming an analog front end (AFE) or a digital front end (DFE). The display device 970 is an electroluminescent (EL) display device or a liquid crystal display device that displays information (image) obtained in the semiconductor apparatus 930. The storage device 980 is a magnetic device or a semiconductor device that stores information (image) obtained in the semiconductor apparatus 930. The storage device 980 is a volatile memory, such as a static RAM (SRAM) or a dynamic RAM (DRAM), or a nonvolatile memory, such as a flash memory or a hard disk drive.

The mechanical device 990 includes a moving unit or a propulsion unit, such as a motor or an engine. In the device 9191, a signal output from the semiconductor apparatus 930 is displayed on the display device 970 and transmitted to the outside by a communication device (not illustrated) included in the device 9191. In this configuration, the device 9191 desirably further includes the storage device 980 and the processing device 960 aside from a storage circuit and a calculation circuit included in the semiconductor apparatus 930. The mechanical device 990 may be controlled based on a signal output from the semiconductor apparatus 930.

The device 9191 is suitable for an electronic device, such as an information terminal having an image capturing function (e.g., smartphone or wearable terminal) or a camera (e.g., interchangeable lens camera, compact camera, video camera, monitoring camera). The mechanical device 990 in a camera drives a component of the optical device 940 for zooming, focusing, or a shutter operation. Alternatively, the mechanical device 990 in a camera moves the semiconductor apparatus 930 for an image stabilization operation.

The device 9191 can be a transport device, such as a vehicle, a ship, or a flight vehicle (drone, airplane, etc.). The mechanical device 990 in a transport device can be used as a moving device. The device 9191 serving as a transport device is suitable for a device that transports the semiconductor apparatus 930, or a device that aids and/or automates driving (steering) using an image capturing function. The processing device 960 for aiding and/or automating driving (steering) performs processing to operate the mechanical device 990 serving as a moving device, based on information obtained in the semiconductor apparatus 930. Alternatively, the device 9191 may be a medical device, such as an endoscope, a measuring device, such as a distance measuring sensor, an analytical device, such as an electronic microscope, an office device, such as a copier, or an industrial device, such as a robot.

According to the above-described embodiment, desirable pixel characteristics are obtainable. This leads to enhancement of the value of the semiconductor apparatus. The enhancement of the value corresponds to at least any of the addition of a function, performance improvement, characteristic improvement, reliability improvement, manufacturing yield ratio improvement, environmental burden reduction, cost reduction, downsizing, and weight saving.

Consequently, using the semiconductor apparatus 930 according to the present embodiment in the device 9191 also leads to enhancement of the value of the device 9191. For example, a transport device on which the semiconductor apparatus 930 is mounted achieves superior performance in the image capturing the outside of the transport device or measuring an external environment. Thus, determining to mount the semiconductor apparatus according to the present embodiment on a transport device when manufacturing and selling the transport device is advantageous in improving the performance of the transport device itself. The semiconductor apparatus 930 is suitable especially for a transport device that performs drive assist and/or automatic operation of the transport device using information obtained in the semiconductor apparatus 930.

A photoelectric conversion system and a movable body according to the present embodiment will be described with reference to Fig. 31B.

Fig. 31B illustrates an example of a photoelectric conversion system related to an in-vehicle camera. A photoelectric conversion system 8 includes a photoelectric conversion apparatus 80. The photoelectric conversion apparatus 80 is the photoelectric conversion apparatus (imaging apparatus) according to any of the above-described embodiments. The photoelectric conversion system 8 includes an image processing unit 801 that performs image processing on a plurality of pieces of image data acquired by the photoelectric conversion apparatus 80, and a parallax acquisition unit 802 that calculates a parallax (phase difference between parallax images) from the plurality of pieces of image data acquired by the photoelectric conversion system 8. Here, the photoelectric conversion system 8 may include an optical system (not illustrated), such as a lens, a shutter, or a mirror that guides light to the photoelectric conversion apparatus 80.

A plurality of photoelectric conversion units approximately equivalent to a pupil of the optical system may be disposed in pixels included in photoelectric conversion apparatus 80. For example, the plurality of photoelectric conversion units approximately equivalent to the pupil are disposed in such a manner as to correspond to one microlens. By the plurality of photoelectric conversion units receiving light beams having passed through mutually-different position of the pupil of the optical system, the photoelectric conversion apparatus 80 outputs image data corresponding to the light beams having passed through the different position. Then, the parallax acquisition unit 802 may calculate a parallax using the output image data. The photoelectric conversion system 8 further includes a distance acquisition unit 803 that calculates a distance to a target object based on the calculated parallax, and a collision determination unit 804 that determines whether collision is likely to occur, based on the calculated distance. In the present embodiment, the parallax acquisition unit 802 and the distance acquisition unit 803 serve as an example of a distance information acquisition unit that acquires distance information regarding a distance to a target object. More specifically, the distance information is information regarding a parallax, a defocus amount, and a distance to a target object. The collision determination unit 804 may determine collision likelihood using any of these pieces of distance information. The distance information may be acquired using a Time-of-Flight (ToF) technique. The distance information acquisition unit may be implemented by dedicatedly-designed hardware, or may be implemented by a software module. The distance information acquisition unit may be implemented by a FPGA) or an ASIC, or may be implemented by the combination of these.

The photoelectric conversion system 8 is connected with a vehicle information acquisition apparatus 810, and can acquire vehicle information, such as vehicle speed, a yaw rate, or a rudder angle. An electronic control unit (ECU) 820 is connected to the photoelectric conversion system 8. The ECU 820 serves as a control apparatus that outputs a control signal to cause a vehicle to generate braking force, based on a determination result obtained by the collision determination unit 804. The photoelectric conversion system 8 is also connected with an alarm apparatus 830 that raises an alarm to a driver, based on a determination result obtained by the collision determination unit 804. For example, in a case where the determination result obtained by the collision determination unit 804 indicates high collision likelihood, the control ECU 820 performs vehicle control to avoid collision or reduce damages by braking, releasing an accelerator, or suppressing engine output. The alarm apparatus 830 issues an alarm to a user by sounding an alarm such as sound, displaying warning information on a screen of a car navigation system, or vibrating a seatbelt or a steering wheel.

In the present embodiment, the photoelectric conversion system 8 captures an image of the periphery of the vehicle, such as the forward image or the backward image, for example.

Fig. 31C illustrates a photoelectric conversion system for capturing a forward image of a vehicle (imaging range 850). The vehicle information acquisition apparatus 810 issues an instruction to the photoelectric conversion system 8 or the photoelectric conversion apparatus 80. With this configuration, the accuracy of distance measurement can be further enhanced.

The above description has been given of an example in which control is performed to avoid a collision with another vehicle. The photoelectric conversion system is also applicable to control for autonomous driving to follow another vehicle, or control for autonomous driving to avoid a deviation from a lane. Furthermore, the photoelectric conversion system 8 is applicable not only to a vehicle, such as an automobile, but also to a movable body (moving apparatus) such as a vessel, an aircraft, or an industrial robot. This movable body includes either one or both of a drive force generation unit that generates drive force to be mainly used for the movement of the movable body, and a rotator to be mainly used for the movement of the movable body. The drive force generation unit can be an engine, a motor, or the like. The rotator can be a tire, a wheel, a screw of a ship, a propeller of a flight vehicle, or the like. Moreover, the photoelectric conversion system can be applied to a device extensively using object recognition, such as an intelligent transport system (ITS), in addition to a movable body.

The various devices have been described in the above-described examples, but a mechanical device may be further included. The mechanical device in a camera can drive the component of an optical device for zooming, focusing, or a shutter operation. Alternatively, the mechanical device in a camera can move a photoelectric conversion apparatus for an image stabilization operation.

The device can be a transport device, such as a vehicle, a ship, or a flight vehicle. The mechanical device in a transport device can be used as a moving device. The device serving as a transport device is suitable for a device that transports the photoelectric conversion apparatus, or a device that aids and/or automates driving (steering) using an image capturing function. A processing device for aiding and/or automating driving (steering) performs processing for operating the mechanical device serving as a moving device, based on information obtained in the photoelectric conversion apparatus.

### [Modified Embodiment]

The present invention is not limited solely to the above-described embodiments, and various modifications can be made without departing from the scope of the invention. For example, an example in which a partial configuration of a certain embodiment is added to another embodiment, and an example in which a partial configuration of a certain embodiment is replaced with a partial configuration of another embodiment are also included in the embodiments of the present invention. The embodiments described above can be implemented solely or as a combination of a plurality of elements or features thereof where necessary or where the combination of the elements or features from individual embodiments in a single embodiment is beneficial.

In the above-described embodiment(s), an example in which a MOS transistor is applied as a transistor has been described, but a transistor other than the MOS transistor may be applied. For example, a bipolar transistor may be used in place of the MOS transistor.

The photoelectric conversion systems described in the above-described third embodiment and the fourth embodiment are examples of the photoelectric conversion systems to which the photoelectric conversion apparatus can be applied, and the photoelectric conversion system to which the photoelectric conversion apparatus of the present invention can be applied is not limited to the configurations illustrated in Figs. 24, 25A, and 25B. The same applies to the ToF system described in the fifth embodiment, the endoscope described in the sixth embodiment, the smart glass described in the seventh embodiment, the smartphone described in the eighth embodiment, the CT apparatus described in the ninth embodiment, and the device described in the tenth embodiment.

The above embodiments are merely examples of embodiments for carrying out the present invention, and the technical scope of the present invention should not be construed as being limited by the embodiments. That is, the present invention can be implemented in various forms without departing from the technical idea or the main features thereof.

As used herein, the phrase "A or B" and the phrase "at least one of A and B" can include all possible combinations of the listed items, unless expressly defined otherwise. Also, expressions, such as "at least one of A or/and B" and "one or more of A or/and B", can include all possible combinations of the listed items, unless expressly defined otherwise. That is, the above expression is understood to disclose all of the following cases: when at least one A is included, when at least one B is included, and when both at least one A and at least one B are included. This applies equally to combinations of three or more elements.

The disclosure includes the following configurations and methods.

### (Configuration 1)

A photoelectric conversion apparatus comprising:
an avalanche photodiode having a first terminal and a second terminal;
a first power source connected to the first terminal;
a second power source connected to the second terminal;
a charge unit configured to control a voltage of the first terminal;
a voltage control unit connected to the first terminal and configured to control a voltage of the first terminal in accordance with a voltage of the first terminal; and
a third power source connected with the voltage control unit.

### (Configuration 2)

The photoelectric conversion apparatus according to configuration 1, wherein a voltage of the third power source is a voltage between a voltage of the first power source and a voltage of the second power source.

### (Configuration 3)

The photoelectric conversion apparatus according to configuration 1, wherein a voltage of the third power source is equal to a voltage of the first power source.

### (Configuration 4)

The photoelectric conversion apparatus according to configuration 1,
wherein the voltage control unit includes a metal-oxide semiconductor (MOS) transistor,
wherein one terminal of the MOS transistor is connected to the first terminal, and
wherein another terminal of the MOS transistor is connected to the third power source.

### (Configuration 5)

The photoelectric conversion apparatus according to configuration 1 or 4, wherein a gate of the MOS transistor is connected to the first terminal.

### (Configuration 6)

The photoelectric conversion apparatus according to any one of configurations 1 to 5, wherein the MOS transistor is a P-type MOS transistor.

### (Configuration 7)

The photoelectric conversion apparatus according to any one of configurations 1 to 5, wherein the MOS transistor is an N-type MOS transistor.

### (Configuration 8)

The photoelectric conversion apparatus according to configuration 1,
wherein the voltage control unit includes a diode,
wherein one terminal of the diode is connected to the first terminal, and
wherein another terminal of the diode is connected to the third power source.

### (Configuration 9)

The photoelectric conversion apparatus according to any one of configurations 1 to 8,
wherein the one terminal of the diode is a cathode, and
wherein the another terminal of the diode is an anode.

### (Configuration 10)

The photoelectric conversion apparatus according to any one of configurations 1 to 8,
wherein the voltage control unit further includes a metal-oxide semiconductor (MOS) transistor,
wherein one terminal of the MOS transistor is connected to the first terminal, and
wherein another terminal of the MOS transistor is connected to the third power source via the diode.

### (Configuration 11)

The photoelectric conversion apparatus according to any one of configurations 1 to 10, wherein a gate of the MOS transistor is connected to the first terminal.

### (Configuration 12)

The photoelectric conversion apparatus according to any one of configurations 1 to 11, wherein the MOS transistor is a P-type MOS transistor.

### (Configuration 13)

The photoelectric conversion apparatus according to any one of configurations 1 to 11, wherein the MOS transistor is an N-type MOS transistor.

### (Configuration 14)

The photoelectric conversion apparatus according to configuration 1, wherein the first terminal is a cathode of the avalanche photodiode.

### (Configuration 15)

The photoelectric conversion apparatus according to configuration 1, wherein the first terminal is an anode of the avalanche photodiode.

### (Configuration 16)

The photoelectric conversion apparatus according to configuration 1, further comprising a waveform shaping unit connected with the first terminal,
wherein the waveform shaping unit is connected to the voltage control unit.

### (Configuration 17)

The photoelectric conversion apparatus according to any one of configurations 1 to 16, further comprising:
a first substrate on which the avalanche photodiode is disposed;
a second substrate on which a first signal processing unit including the charge unit, the voltage control unit, and the waveform shaping unit is disposed; and
a third substrate on which a second signal processing unit configured to process a signal output from the waveform shaping unit is disposed.

### (Configuration 18)

The photoelectric conversion apparatus according to any one of configurations 1 to 17, wherein the second signal processing unit includes a counter configured to count a signal output from the waveform shaping unit.

### (Configuration 19)

The photoelectric conversion apparatus according to any one of configurations 1 to 18,
wherein the charge unit includes a metal-oxide semiconductor (MOS) transistor, and
wherein a clock signal is input to a gate of the MOS transistor of the charge unit.

### (Configuration 20)

A photoelectric conversion system comprising:
the photoelectric conversion apparatus according to any one of configurations 1 to 19; and
a signal processing unit configured to generate an image using a signal output from the photoelectric conversion apparatus.

### (Configuration 21)

A movable body including the photoelectric conversion apparatus according to any one of configurations 1 to 19, the movable body comprising:
a control unit configured to control a movement of the movable body using a signal output from the photoelectric conversion apparatus.

According to the present invention, it is possible to provide a photoelectric conversion apparatus that addresses an issue that occurs in a standby state in which a charge unit and a power source are disconnected.

While the present invention has been described with reference to embodiments, it is to be understood that the invention is not limited solely to the disclosed embodiments. The scope of the following claims is to be accorded the broadest interpretation so as to encompass all such modifications and equivalent structures and functions as understood by the skilled person.

## Claims

1. A photoelectric conversion apparatus (100) comprising:
an avalanche photodiode (201) having a first terminal and a second terminal;
a first power source (601, 1301) connected to the first terminal;
a second power source (602, 1302) connected to the second terminal;
charge means (202) for controlling a voltage of the first terminal;
voltage control means (604), connected to the first terminal, for controlling a voltage of the first terminal in accordance with a voltage of the first terminal; and
a third power source (603, 1303) connected with the voltage control means.

2. The photoelectric conversion apparatus (100) according to claim 1, wherein a voltage of the third power source (603, 1303) is a voltage between a voltage of the first power source (601, 1301) and a voltage of the second power source (602, 1302).

3. The photoelectric conversion apparatus (100) according to claim 1, wherein a voltage of the third power source (603, 1303) is equal to a voltage of the first power source (601, 1301).

4. The photoelectric conversion apparatus (100) according to any one of claims 1 to 3,
wherein the voltage control means (604) includes a metal-oxide semiconductor (MOS) transistor,
wherein one terminal of the MOS transistor is connected to the first terminal, and
wherein another terminal of the MOS transistor is connected to the third power source.

5. The photoelectric conversion apparatus (100) according to claim 4, wherein a gate of the MOS transistor is connected to the first terminal.

6. The photoelectric conversion apparatus (100) according to claim 4 or claim 5, wherein the MOS transistor is a P-type MOS transistor.

7. The photoelectric conversion apparatus (100) according to claim 4 or claim 5, wherein the MOS transistor is an N-type MOS transistor.

8. The photoelectric conversion apparatus (100) according to any one of claims 1 to 7,
wherein the voltage control (604) means includes a diode (1006, 1106),
wherein one terminal of the diode is connected to the first terminal, and
wherein another terminal of the diode is connected to the third power source (603, 1303).

9. The photoelectric conversion apparatus (100) according to claim 8,
wherein the one terminal of the diode (1006, 1106) is a cathode, and
wherein the another terminal of the diode is an anode.

10. The photoelectric conversion apparatus (100) according to claim 8 or claim 9,
wherein the voltage control means (604) further includes a metal-oxide semiconductor (MOS) transistor (905, 1105, 1120),
wherein one terminal of the MOS transistor is connected to the first terminal, and
wherein another terminal of the MOS transistor is connected to the third power source via the diode.

11. The photoelectric conversion apparatus (100) according to claim 10, wherein a gate of the MOS transistor is connected to the first terminal.

12. The photoelectric conversion apparatus (100) according to claim10 or claim 11, wherein the MOS transistor is a P-type MOS transistor.

13. The photoelectric conversion apparatus (100) according to claim 10 or claim 11, wherein the MOS transistor is an N-type MOS transistor.

14. The photoelectric conversion apparatus (100) according to any one of claims 1 to 13, wherein the first terminal is a cathode of the avalanche photodiode (201).

15. The photoelectric conversion apparatus (100) according to any one of claims 1 to 14, wherein the first terminal is an anode of the avalanche photodiode (201).

16. The photoelectric conversion apparatus (100) according to any one of claims 1 to 15, further comprising waveform shaping means (210) connected with the first terminal,
wherein the waveform shaping means is connected to the voltage control means (604).

17. The photoelectric conversion apparatus (100) according to claim 16, further comprising:
a first substrate (11) on which the avalanche photodiode (201) is disposed;
a second substrate (21) on which first signal processing means (103) including the charge means (202), the voltage control means (604), and the waveform shaping means (210) is disposed; and
a third substrate on which second signal processing means for processing a signal output from the waveform shaping means is disposed.

18. The photoelectric conversion apparatus (100) according to claim 17, wherein the second signal processing means (103) includes a counter (211) for counting a signal output from the waveform shaping means (210).

19. The photoelectric conversion apparatus (100) according to any one of claims 1 to 18,
wherein the charge means (202) includes a metal-oxide semiconductor (MOS) transistor, and
wherein a clock signal is input to a gate of the MOS transistor of the charge means.

20. A photoelectric conversion system comprising:
the photoelectric conversion apparatus (100) according to any one of claims 1 to 19; and
signal processing means for generating an image using a signal output from the photoelectric conversion apparatus.

21. A movable body including the photoelectric conversion apparatus (100) according to any one of claims 1 to 19, the movable body comprising:
control means for controlling a movement of the movable body using a signal output from the photoelectric conversion apparatus.
